# EUROPEAN PATENT APPLICATION

(11) **EP 4 270 108 A1**
(43) Date of publication of application: **01.11.2023**
(21) Application number: 23169951.3
(22) Date of filing: 26.04.2023
(51) Int. Cl.: G03F 7/004, G03F 7/039

(54) **CHEMICALLY AMPLIFIED POSITIVE RESIST COMPOSITION AND RESIST PATTERN FORMING PROCESS**

(30) Priority: 26.04.2022 JP 2022072507
(71) Applicant: Shin-Etsu Chemical Co., Ltd., Tokyo (JP)
(72) Inventor: KOTAKE, Masaaki, Joetsu-shi (JP); WATANABE, Satoshi, Joetsu-shi (JP); MASUNAGA, Keiichi, Joetsu-shi (JP); FUKUSHIMA, Masahiro, Joetsu-shi (JP); FUNATSU, Kenji, Joetsu-shi (JP); MATSUZAWA, Yuta, Joetsu-shi (JP)
(74) Representative: Ter Meer Steinmeister & Partner

(57) **Abstract**

A chemically amplified positive resist composition is provided comprising (A) an acid diffusion-controlling agent in the form of an onium salt compound having a specific phenoxide anion, (B) a polymer comprising specific repeat units and adapted to be decomposed under the action of acid to increase its solubility in alkaline developer, and (C) a photoacid generator. A resist pattern with a high resolution, reduced LER, and improved CDU is formed. Because of minimal defects, the resist pattern can be inspected with light of short wavelength 300-400 nm.

## Description

### TECHNICAL FIELD

This invention relates to a chemically amplified positive resist composition and a resist pattern forming process using the same.

### BACKGROUND ART

To meet the demand for higher integration density and operating speed of LSIs, the effort to reduce the pattern rule is in rapid progress. Acid-catalyzed chemically amplified resist compositions are most often used in forming resist patterns with a feature size of 0.2 µm or less. High-energy radiation such as UV, deep-UV, or EB is used as the energy source for exposure of these resist compositions. While the EB lithography is utilized as the ultra-fine microfabrication technique, it is also indispensable in processing a photomask blank into a photomask for use in the fabrication of semiconductor devices.

Polymers containing abundant aromatic skeletons with acidic side chains, for example, polyhydroxystyrene are useful as the resist material for KrF excimer laser lithography, but not used as the resist material for ArF excimer laser lithography because of substantial absorption of light near to wavelength 200 nm. The above polymers are yet important, because of high etching resistance, as the resist materials for the EB lithography and EUV lithography which are promising for forming patterns of smaller size than the processing limit of ArF excimer laser.

In positive tone resist materials for the EB lithography and resist materials for the EUV lithography, a base polymer having on a phenol side chain an acidic functional group masked with an acid-decomposable protective group (or acid labile group) is often used in combination with a photoacid generator. Under the catalysis of an acid generated from the photoacid generator upon exposure to high-energy radiation, the protective group is deprotected so that the polymer may become solubilized in alkaline developer.

For the control of resist sensitivity and pattern profile, various improvements are made through a choice and combination of components in a resist composition and adjustment of processing conditions. One of such improvements relates to the diffusion of acid. Enormous studies are made on the problem of acid diffusion that largely affects the sensitivity and resolution of chemically amplified resist compositions.

Patent Documents 1 and 2 describe photoacid generators capable of generating bulky benzenesulfonic acids upon light exposure for controlling acid diffusion and reducing roughness (LER). Since these acid generators are still insufficient to control acid diffusion, it is desired to have an acid generator with more controlled diffusion.

Patent Document 3 discloses a resist composition comprising a base polymer having bound thereto an acid generator capable of generating a sulfonic acid upon light exposure whereby acid diffusion is controlled. This approach of controlling acid diffusion by binding repeat units capable of generating acid upon exposure to a base polymer is effective in forming a pattern with reduced LER. However, the base polymer having bound therein repeat units capable of generating acid upon exposure encounters a problem with respect to its solubility in organic solvent, depending on the structure and proportion of the repeat units.

With the aim of suppressing acid diffusion, a method of improving an acid diffusion-controlling agent or quencher is contemplated as well as the above-mentioned method of generating a bulky acid. The acid diffusion-controlling agent serves to suppress acid diffusion and in fact, is essential for improving the properties of a resist composition. While a variety of studies have been made on the acid diffusion-controlling agent, amines and weak acid onium salts are generally used. As one exemplary weak acid onium salt, Patent Document 4 describes that the addition of triphenylsulfonium acetate enables to form a resist pattern which overcomes the problems of T-top formation, a difference in line width between isolated and grouped features, and standing waves. Patent Document 5 describes that the addition of a sulfonic acid ammonium salt or carboxylic acid ammonium salt leads to improvements in sensitivity, resolution, and exposure margin. Patent Document 6 describes a resist composition for the KrF lithography and EB lithography comprising a photoacid generator capable of generating a fluorinated carboxylic acid, which is improved in resolution and process allowances such as exposure margin and depth of focus. These resist compositions are used in the KrF lithography, EB lithography, and F₂ lithography.

Patent Document 7 discloses a positive photosensitive composition for the ArF lithography comprising a carboxylic acid onium salt. Upon light exposure, a photoacid generator generates a strong acid (sulfonic acid) which exchanges with the weak acid onium salt to release a weak acid and a strong acid onium salt. That is, the strong acid having high acidity (sulfonic acid) is replaced by the weak acid (carboxylic acid), for thereby suppressing the acid decomposition reaction of the acid labile group and reducing or controlling the distance of acid diffusion. The onium salt apparently functions as the acid diffusion-controlling agent.

When patterns are formed from the resist compositions comprising a carboxylic acid onium salt or fluorocarboxylic acid onium salt as mentioned above, however, a serious problem of LER arises in the current technology of advanced miniaturization. It is desired to have an acid diffusion-controlling agent capable of reducing LER.

With the aim of reducing LER, it is also known to add an acid diffusion-controlling agent in a large amount relative to an acid generator to suppress acid diffusion. Since the acid diffusion-controlling agent in the form of an onium salt is poorly soluble in the resist solvent, agglomerates form, giving rise to the problem of defects.

In the recent trend to form patterns having a smaller feature size, it is required to apply an inspection tool using light of a short wavelength to detect microscopic defects. Since the resist material is absorptive to inspection light of short wavelength of 400 nm or less, there arises the problem that the resist film is degraded by the inspection light.

Patent Document 8 discloses a resist composition comprising triphenylsulfonium phenolate. In view of the recent demand for dimensional uniformity (CDU), the resist composition of Patent Document 8 still suffers from a shortage of CDU.

### Citation List

Patent Document 1: JP-A 2009-053518
Patent Document 2: JP-A 2010-100604
Patent Document 3: JP-A 2011-022564
Patent Document 4: JP 3955384
Patent Document 5: JP-A H11-327143
Patent Document 6: JP 4231662
Patent Document 7: JP 4226803
Patent Document 8: JP-A 2016-006495
Patent Document 9: JP 4575479

### SUMMARY OF INVENTION

An object of the invention is to provide a chemically amplified positive resist composition which is improved in resolution upon pattern formation, and forms a resist pattern with a reduced LER and improved CDU, which pattern contains only a few defects and can be inspected for defects with inspection light of short wavelength 300 to 400 nm, and a pattern forming process using the same.

The inventors have found that a resist composition comprising an acid diffusion-controlling agent in the form of an onium salt compound having a specific phenoxide anion offers a high resolution, forms a resist pattern of satisfactory profile with improved LER and CDU, which pattern contains only fewer defects and is not absorptive to light of short wavelength 300 to 400 nm.

Accordingly, the invention provides a chemically amplified positive resist composition and resist pattern forming process, as defined below.
1. A chemically amplified positive resist composition comprising
   (A) an onium salt compound having the formula (A1),
   (B) a base polymer containing a polymer comprising repeat units having the formula (B1) and adapted to be decomposed under the action of acid to increase its solubility in alkaline developer, but not containing a polymer comprising lactone ring-bearing repeat units, and
   (C) a photoacid generator,
      wherein the content of repeat units of aromatic ring structure is at least 65 mol% of the overall repeat units of the polymer in the base polymer, a ratio of the amount of the photoacid generator to the amount of the onium salt compound having formula (A1) is less than 4, the amount of the photoacid generator is at least 5 parts by weight per 80 parts by weight of the polymer, the total amount of the onium salt compound having formula (A1) and the photoacid generator is at least 10 parts by weight per 80 parts by weight of the polymer, 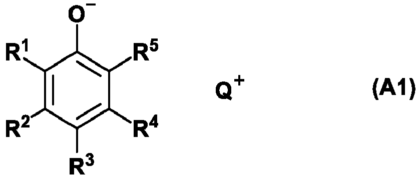 wherein R¹ to R⁵ are each independently hydrogen, halogen, nitro, cyano, aldehyde, a C₁-C₁₈ hydrocarbyl group which may contain a heteroatom, -C(O)OR⁶, -C(O)R⁷, -OR⁸, -S(O)₂R⁹, or -S(O)₂N(R¹⁰)₂, wherein R⁶ and R⁷ are each independently a C₁-C₁₉ hydrocarbyl group which may contain a heteroatom, R⁸ and R⁹ are each independently a C₁-C₂₀ hydrocarbyl group which may contain a heteroatom, R¹⁰ is each independently hydrogen or a C₁-C₂₀ hydrocarbyl group which may contain a heteroatom,
      Q⁺ is a sulfonium cation having the formula (A2) or iodonium cation having the formula (A3): 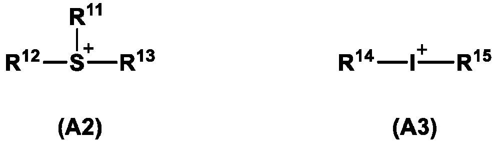 wherein R¹¹ to R¹⁵ are each independently a C₁-C₂₀ hydrocarbyl group which may contain a heteroatom, R¹¹ and R¹² may bond together to form a ring with the sulfur atom to which they are attached, 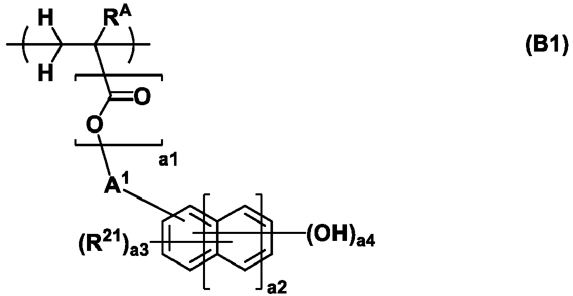 wherein R^{A} is hydrogen, fluorine, methyl or trifluoromethyl,
      a1 is 0 or 1, a2 is an integer of 0 to 2, a3 is an integer meeting 0 ≤ a3 ≤ 5+2a2-a4, a4 is an integer of 1 to 3,
      R²¹ is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group,
      A¹ is a single bond or a C₁-C₁₀ saturated hydrocarbylene group in which any constituent -CH₂- may be replaced by -O-.
2. The resist composition of 1 wherein at least one of R¹ to R⁵ is a group containing fluorine, chlorine, bromine or iodine.
3. The resist composition of 1 or 2 wherein the repeat unit having formula (B1) has the formula (B 1-1): 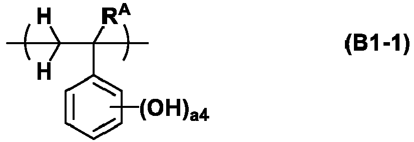 wherein R^{A} and a4 are as defined above.
4. The resist composition of any one of 1 to 3 wherein the polymer further comprises repeat units having the formula (B2): 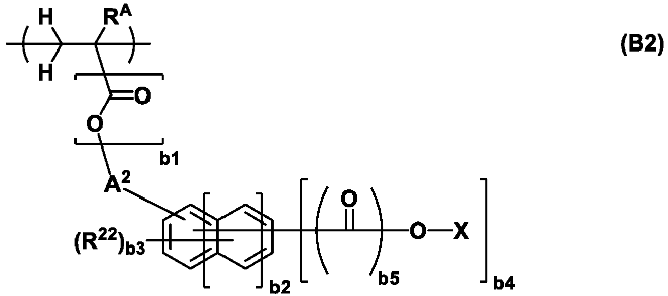 wherein R^{A} is as defined above,
   b1 is 0 or 1, b2 is an integer of 0 to 2, b3 is an integer meeting 0 ≤ b3 ≤ 5+2b2-b4, b4 is an integer of 1 to 3, b5 is 0 or 1,
   R²² is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group,
   A² is a single bond or a C₁-C₁₀ saturated hydrocarbylene group in which any constituent -CH₂- may be replaced by -O-,
   X is an acid labile group when b4 is 1, and hydrogen or an acid labile group, at least one X being an acid labile group, when b4 is 2 or 3.
5. The resist composition of any one of 1 to 4 wherein the polymer further comprises repeat units of at least one type selected from repeat units having the formula (B3), repeat units having the formula (B4), and repeat units having the formula (B5): 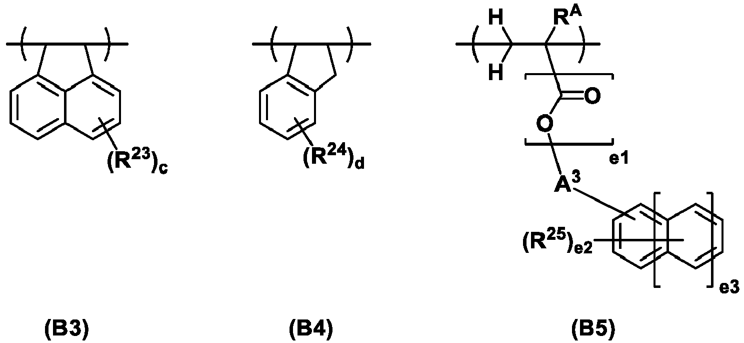 wherein R^{A} is as defined above,
   c and d are each independently an integer of 0 to 4, e1 is 0 or 1, e2 is an integer of 0 to 5, e3 is an integer of 0 to 2,
   R²³ and R²⁴ are each independently hydroxy, halogen, an optionally halogenated C₂-C₈ saturated hydrocarbylcarbonyloxy group, optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group,
   R²⁵ is acetyl, a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro, cyano, sulfinyl or sulfonyl, and
   A³ is a single bond or a C₁-C₁₀ saturated hydrocarbylene group in which any constituent -CH₂- may be replaced by -O-.
6. The resist composition of any one of 1 to 5 wherein the polymer further comprises repeat units of at least one type selected from repeat units having the formulae (B6) to (B 13): 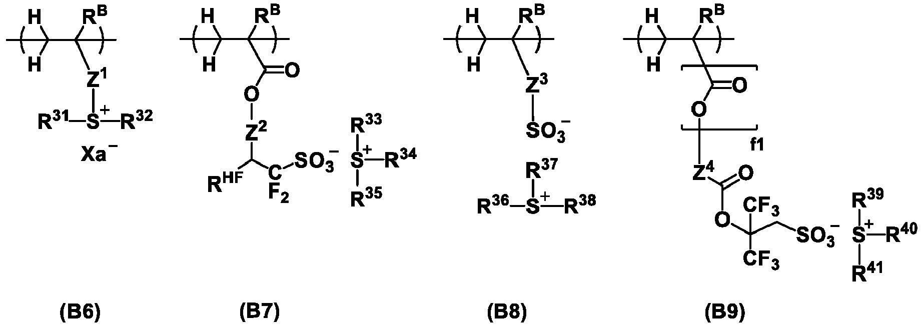 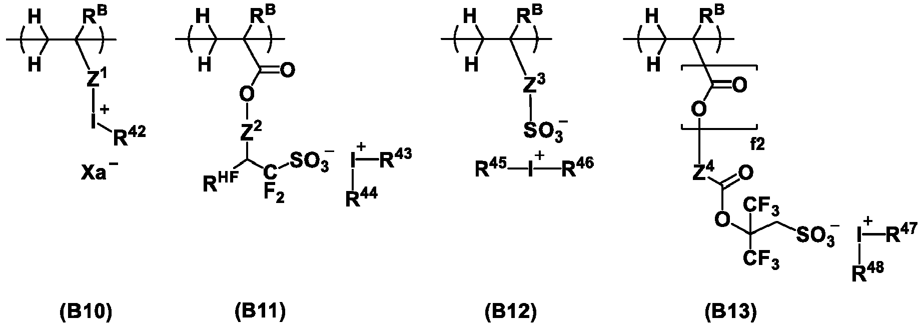 wherein R^{B} is hydrogen or methyl,
   Z¹ is a single bond, a C₁-C₆ aliphatic hydrocarbylene group, phenylene group, naphthylene group or C₇-C₁₈ group obtained by combining the foregoing, -O-Z¹¹-, - C(=O)-O-Z¹¹-, or -C(=O)-NH-Z¹¹-, Z¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety,
   Z² is a single bond or -Z²¹-C(=O)-O-, Z²¹ is a C₁-C₂₀ hydrocarbylene group which may contain a heteroatom,
   Z³ is a single bond, methylene, ethylene, phenylene, fluorinated phenylene, trifluoromethyl-substituted phenylene, -O-Z³¹-, -C(=O)-O-Z³¹-, or -C(=O)-NH-Z³¹-, Z³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety,
   Z⁴ is a single bond or C₁-C₃₀ hydrocarbylene group which may contain a heteroatom, f1 and f2 are each independently 0 or 1, f1 and f2 are 0 when Z⁴ is a single bond,
   R³¹ to R⁴⁸ are each independently a C₁-C₂₀ hydrocarbyl group which may contain a heteroatom, R³¹ and R³² may bond together to form a ring with the sulfur atom to which they are attached, R³³ and R³⁴, R³⁶ and R³⁷, or R³⁹ and R⁴⁰ may bond together to form a ring with the sulfur atom to which they are attached,
   R^{HF} is hydrogen or trifluoromethyl, and
   Xa⁻ is a non-nucleophilic counter ion.
7. The resist composition of any one of 1 to 6, further comprising (D) a polymer comprising repeat units having the following formula (D1), and repeat units of at least one type selected from repeat units having the following formulae (D2) to (D5): 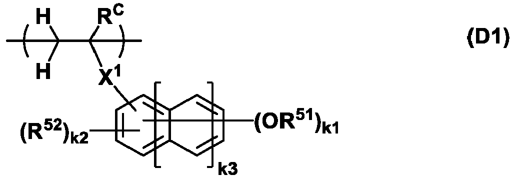 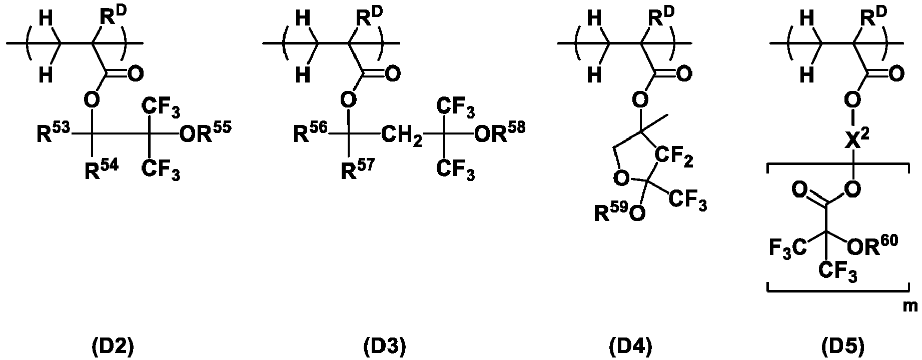 wherein R^{C} is each independently hydrogen or methyl,
   R^{D} is each independently hydrogen, fluorine, methyl or trifluoromethyl,
   R⁵¹ is hydrogen or a C₁-C₅ straight or branched hydrocarbyl group in which a heteroatom-containing moiety may intervene in a carbon-carbon bond,
   R⁵² is a C₁-C₅ straight or branched hydrocarbyl group in which a heteroatom-containing moiety may intervene in a carbon-carbon bond,
   R⁵³, R⁵⁴, R⁵⁶ and R⁵⁷ are each independently hydrogen or a C₁-C₁₀ saturated hydrocarbyl group,
   R⁵⁵ R⁵⁸, R⁵⁹ and R⁶⁰ are each independently hydrogen or a C₁-C₁₅ hydrocarbyl group, C₁-C₁₅ fluorinated hydrocarbyl group, or acid labile group, when R⁵⁵, R⁵⁸, R⁵⁹ and R⁶⁰ each are a hydrocarbyl or fluorinated hydrocarbyl group, an ether bond or carbonyl moiety may intervene in a carbon-carbon bond,
   k1 is an integer of 1 to 3, k2 is an integer meeting 0 ≤ k2 ≤ 5+2k3-k1, k3 is 0 or 1, m is an integer of 1 to 3,
   X¹ is a single bond, -C(=O)-O- or -C(=O)-NH-, and
   X² is a C₁-C₂₀ (m+1)-valent hydrocarbon group or C₁-C₂₀ (m+1)-valent fluorinated hydrocarbon group.
8. The resist composition of any one of 1 to 7, further comprising (E) an organic solvent.
9. The resist composition of any one of 1 to 8 which forms a resist film having an extinction coefficient (k value) of up to 0.01 relative to inspection light of wavelength 300 to 400 nm.
10. A resist pattern forming process comprising the steps of:
   applying the chemically amplified positive resist composition of any one of 1 to 9 onto a substrate to form a resist film thereon,
   exposing the resist film patternwise to high-energy radiation, and
   developing the exposed resist film in an alkaline developer.
11. The process of 10 wherein the high-energy radiation is EUV or EB.
12. The process of 10 or 11 wherein the substrate has the outermost surface of a material containing at least one element selected from chromium, silicon, tantalum, molybdenum, cobalt, nickel, tungsten, and tin.
13. The process of any one of 10 to 12 wherein the substrate is a photomask blank.
14. A photomask blank comprising a resist film of the chemically amplified positive resist composition of any one of claims 1 to 9.
15. The photomask blank of claim 14, further comprising an antistatic film.

### ADVANTAGEOUS EFFECTS OF INVENTION

In the chemically amplified positive resist composition, the onium salt compound having formula (A1) is effective for controlling acid diffusion upon light exposure for pattern formation. When applied as a resist film and processed to form a pattern, the resist composition exhibits a very high resolution and forms a pattern with improved LER and CDU. Since the onium salt compound is highly soluble in the solvent in the resist composition, this acid diffusion-controlling agent does not agglomerate together and restrains defect formation. Since the onium salt compound is not sensitive to inspection light of short wavelength 300 to 400 nm, it is possible to inspect microscopic defects with light of short wavelength. Due to the function of the repeat units having formula (B 1), the resist composition, when applied to a substrate, tightly adheres to the substrate and the resist film is fully dissolvable in alkaline developer.

The pattern forming process using the positive resist composition can form a resist pattern with a high resolution, reduced LER and improved CDU. The resist pattern contains only a few defects and can be inspected for microscopic defects with light of short wavelength. The positive resist composition is best suited in the micropatterning technology, typically EUV or EB lithography.

### BRIEF DESCRIPTION OF DRAWINGS

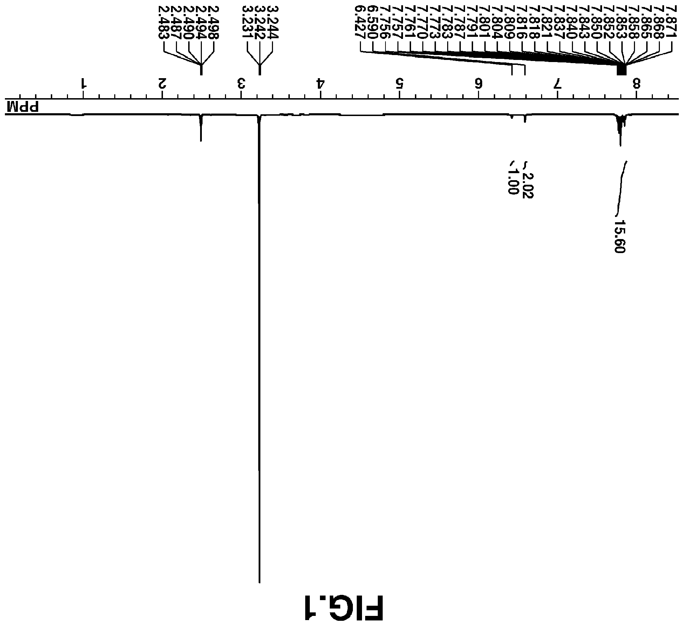

FIG. 1 is a diagram showing the ¹H-NMR spectrum of Compound Q-A in Synthesis Example 1.

### DESCRIPTION OF EMBODIMENTS

As used herein, the singular forms "a," "an" and "the" include plural referents unless the context clearly dictates otherwise. "Optional" or "optionally" means that the subsequently described event or circumstances may or may not occur, and that description includes instances where the event or circumstance occurs and instances where it does not. The notation (Cn-Cm) means a group containing from n to m carbon atoms per group. The terms "group" and "moiety" are interchangeable. In chemical formulae, Me stands for methyl, Ac stands for acetyl, and the broken line designates a valence bond.

The abbreviations and acronyms have the following meaning.
EB: electron beam
EUV: extreme ultraviolet
Mw: weight average molecular weight
Mn: number average molecular weight
Mw/Mn: molecular weight distribution or dispersity
GPC: gel permeation chromatography
PEB: post-exposure bake
PAG: photoacid generator
LER: line edge roughness
CDU: critical dimension uniformity

It is understood that for some structures represented by chemical formulae, there can exist enantiomers and diastereomers because of the presence of asymmetric carbon atoms. In such a case, a single formula collectively represents all such isomers. The isomers may be used alone or in admixture.

### Positive resist composition

One embodiment of the invention is a chemically amplified positive resist composition comprising (A) a specific onium salt compound, (B) a base polymer containing a specific polymer, and (C) a photoacid generator.

### (A) Onium salt compound

Component (A) is an onium salt compound having the formula (A1).

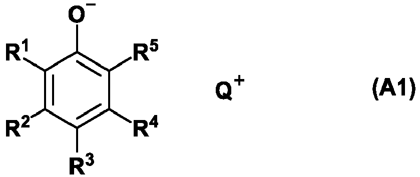

In formula (A1), R¹ to R⁵ are each independently hydrogen, halogen, nitro, cyano, aldehyde, a C₁-C₁₈ hydrocarbyl group which may contain a heteroatom, -C(O)OR⁶, -C(O)R⁷, - OR⁸, -S(O)₂R⁹, or -S(O)₂N(R¹⁰)₂. Herein R⁶ and R⁷ are each independently a C₁-C₁₉ hydrocarbyl group which may contain a heteroatom, R⁸ and R⁹ are each independently a C₁-C₂₀ hydrocarbyl group which may contain a heteroatom, and R¹⁰ is each independently hydrogen or a C₁-C₂₀ hydrocarbyl group which may contain a heteroatom.

Suitable halogen atoms represented by R¹ to R⁵ include fluorine, chlorine, bromine and iodine.

The hydrocarbyl group represented by R¹ to R¹⁰ may be saturated or unsaturated and straight, branched or cyclic. Examples thereof include alkyl groups such as methyl, ethyl, n-propyl, isopropyl, n-butyl, sec-butyl, tert-butyl, tert-pentyl, n-pentyl, n-hexyl, n-octyl, 2-ethylhexyl, n-nonyl and n-decyl; cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decanyl, adamantyl, and adamantylmethyl; alkenyl groups such as vinyl, allyl, propenyl, butenyl, hexenyl; cyclic unsaturated aliphatic hydrocarbyl groups such as cyclohexenyl; C₆-C₂₀ aryl groups such as phenyl, naphthyl and anthracenyl; and combinations thereof. In the hydrocarbyl groups, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy, fluorine, chlorine, bromine, iodine, cyano, nitro, carbonyl, ether bond, ester bond, sulfonic ester bond, carbonate bond, lactone ring, sultone ring, carboxylic anhydride (-C(=O)-O-C(=O)-) or haloalkyl moiety.

R¹ to R⁵ are preferably selected from halogen, C₁-C₆ alkyl groups, C₁-C₆ halogenated alkyl groups, C₁-C₆ hydroxyalkyl groups, C₁-C₆ alkyloxy groups, and C₁-C₆ halogenated alkyloxy groups.

Examples of the anion in the onium salt compound having formula (A1) are shown below, but not limited thereto.

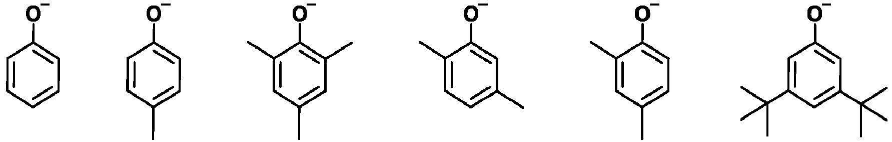

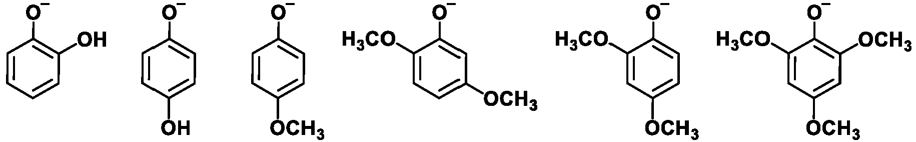

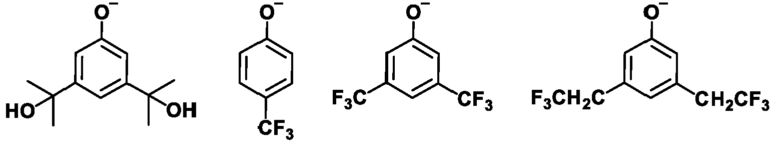

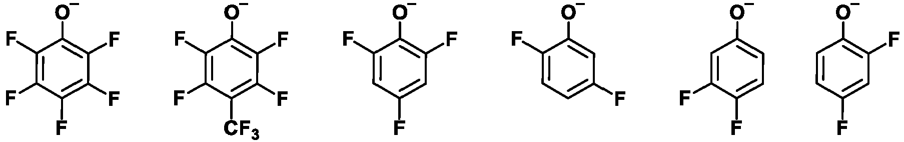

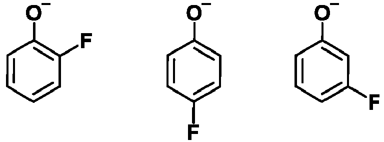

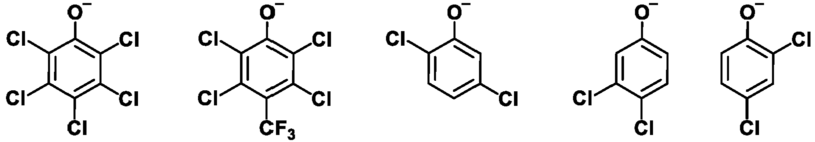

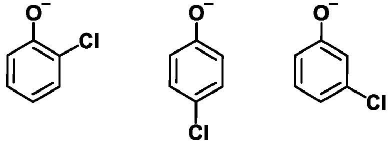

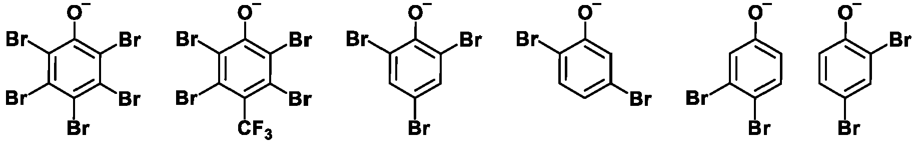

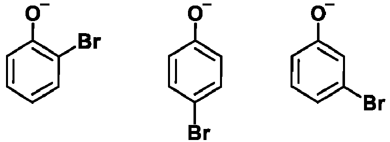

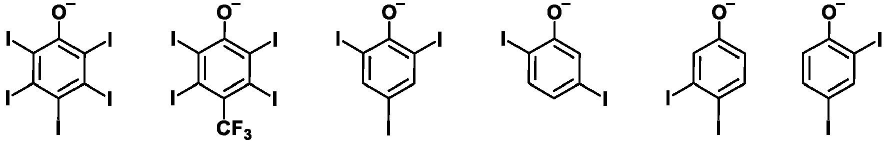

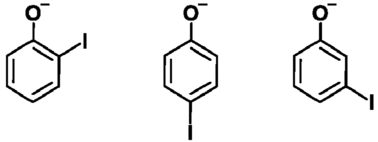

In formula (A1), Q⁺ is a sulfonium cation having the formula (A2) or iodonium cation having the formula (A3).

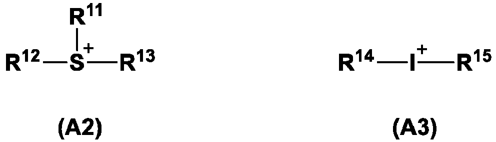

In formulae (A2) and (A3), R¹¹ to R¹⁵ are each independently a C₁-C₂₀ hydrocarbyl group which may contain a heteroatom. R¹¹ and R¹² may bond together to form a ring with the sulfur atom to which they are attached.

The hydrocarbyl groups represented by R¹¹ to R¹⁵ may be saturated or unsaturated and straight, branched or cyclic. Examples thereof are as exemplified above for the hydrocarbyl groups R¹ to R¹⁰ in formula (A1). Preferably, R¹¹ to R¹⁵ are aryl groups.

R¹¹ and R¹² may bond together to form a ring with the sulfur atom to which they are attached. Preferred examples of the ring are those having the following structure.

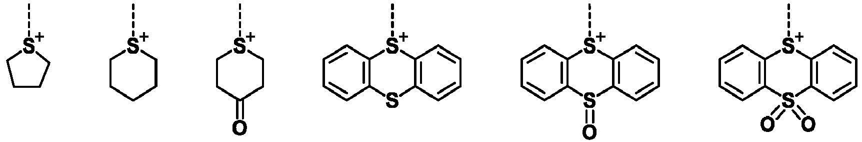

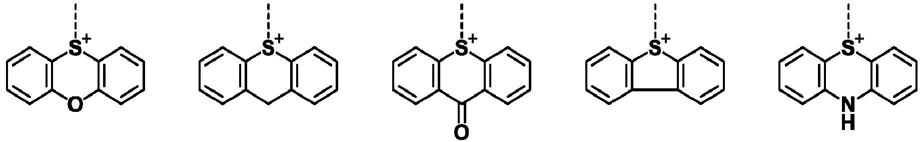

Examples of the sulfonium cation having formula (A2) are shown below, but not limited thereto.

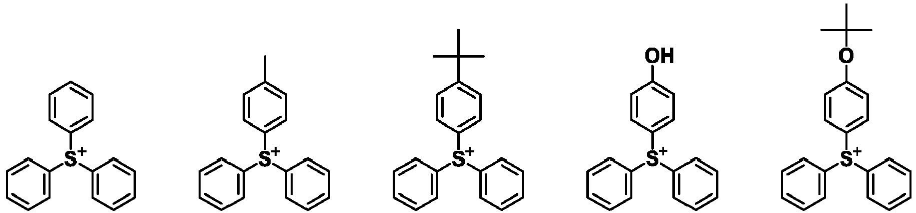

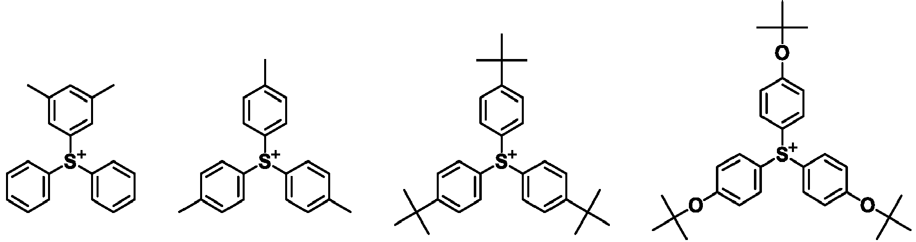

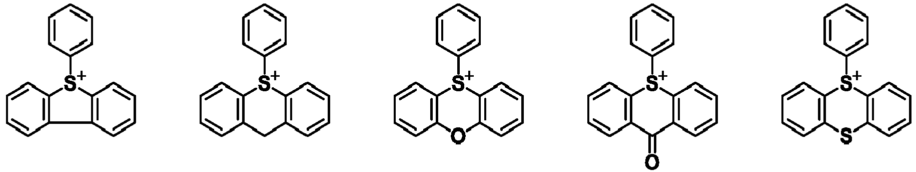

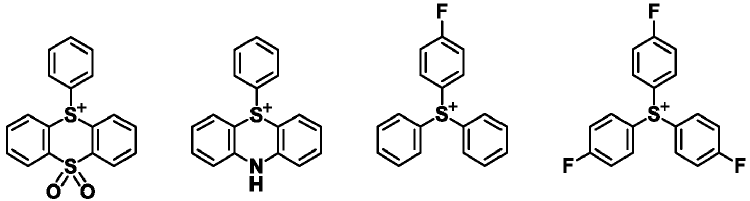

Examples of the iodonium cation having formula (A3) include bis(4-methylphenyl)iodonium, bis(4-ethylphenyl)iodonium, bis(4-tert-butylphenyl)iodonium, bis[4-(1,1-dimethylpropyl)phenyl)iodonium, 4-methoxyphenylphenyliodonium, 4-tert-butoxyphenylphenyliodonium, 4-acryloyloxyphenylphenyliodonium, and 4-methacryloyloxyphenylphenyliodonium. Inter alia, bis(4-tert-butylphenyl)iodonium is preferred.

Exemplary structures of the onium salt include any combinations of the anion with the cation, as exemplified above.

The onium salt compound having formula (A1) quite effectively functions as an acid diffusion-controlling agent when applied to chemically amplified positive resist compositions. As used herein, the term "acid diffusion-controlling agent" refers to a compound capable of trapping the acid generated from the photoacid generator in the chemically amplified positive resist composition for thereby preventing the acid from diffusing into the unexposed region and forming the desired pattern.

It is believed that the onium salt compound follows an acid diffusion-controlling mechanism as described below. The acid generated from the PAG in the resist composition must have a sufficiently strong acidity to deprotect acid labile groups on the base polymer. In the EB lithography, for example, a sulfonic acid which is fluorinated at α-position relative to sulfo group or a non-fluorinated sulfonic acid is generally used. In the resist composition wherein the PAG and the onium salt compound coexist, the acid generated from the PAG is trapped by the onium salt compound, which is in turn converted to a phenol compound. It is also contemplated that the onium salt compound itself undergoes photolysis. In this case, a phenol compound of weak acid is generated, which is insufficient to deprotect acid labile groups on the base polymer. Accordingly, the onium salt compound strongly functions as the acid diffusion-controlling agent.

The acid diffusion-controlling agent, which may also be referred to as onium salt type quencher, generally tends to reduce the LER of resist patterns as compared with a conventional acid diffusion-controlling agent in the form of an amine compound. This is assumably caused by infinite recurrence of salt exchange between the strong acid and the onium salt compound. That is, the site where strong acid is generated at the end of light exposure shifts from the site where the onium salt of strong acid generation type is initially located. It is believed that since the cycle of photo-induced acid generation and salt exchange is repeated many times, the points of acid generation are averaged. Due to this smoothing effect, the resist pattern as developed is reduced in LWR.

Since the onium salt compound having formula (A1) is neither sensitive nor absorptive in the short wavelength region of 300 to 400 nm, a resist film of the positive resist composition can be inspected for microscopic defects by an inspection instrument using inspection light of short wavelength. The instrument for detecting microscopic defects in the resist film typically uses inspection light of wavelength 355 nm, although the wavelength of inspection light is not limited thereto.

In order that the resist film of the positive resist composition be insensitive to the inspection light, the resist film should preferably have an extinction coefficient (k value) of up to 0.01, more preferably up to 0.005, even more preferably up to 0.003.

In formula (A1), preferably at least one of R¹ to R⁵ contains fluorine, chlorine, bromine or iodine. More preferably, at least one of R¹ to R⁵ is halogen, a C₁-C₆ halogenated alkyl group, or C₁-C₆ halogenated alkyloxy group. With this choice, the onium salt compound of formula (A1) is more soluble in the organic solvent of the resist composition. Even when the onium salt compound of formula (A1) is added in a large amount relative to the acid generator for the purpose of improving LER, the onium salt compound does not agglomerate together so that defect formation is prevented.

In an embodiment wherein an antistatic film is formed on a resist film, it is preferred for the onium salt compound of formula (A1) that at least one of R¹ to R⁵ contains fluorine, chlorine, bromine or iodine. More preferably, at least one of R¹ to R⁵ is halogen, a C₁-C₆ halogenated alkyl group, or C₁-C₆ halogenated alkyloxy group. Since the onium salt compound of formula (A1) is kept dispersed in the resist film without agglomeration, the onium salt compound is able to effectively trap a very weak acid in the antistatic film. Further, when at least one of R¹ to R⁵ in formula (A1) contains fluorine, the onium salt compound of formula (A1) is localized near the interface between the resist film and the antistatic film, and is thus able to more effectively trap a very weak acid in the antistatic film. This prevents the antistatic film from deteriorating the resolution of the resist film. The resist film maintains a satisfactory resolution even when it is coated with an antistatic film.

In the chemically amplified positive resist composition, the onium salt compound of formula (A1) is present in an amount of preferably 0.1 to 100 parts by weight, more preferably 1 to 80 parts by weight per 80 parts by weight of the base polymer (B) to be described below. As long as the amount of the onium salt compound is in the range, it functions as an acid diffusion-controlling agent to a full extent, eliminating the risks of degrading resist properties such as a sensitivity drop and defect formation due to a lack of solubility. The onium salt compound of formula (A1) may be used alone or in admixture of two or more.

Also, a ratio of the amount of the photoacid generator to the amount of the onium salt compound having formula (A1) is preferably less than 4/1, more preferably less than 3/1. A ratio in the range ensures sufficient suppression of acid diffusion and assists in achieving improved resolution and CDU.

Further preferably, the amount of the photoacid generator added is at least 5 parts by weight per 80 parts by weight of the polymer and the total amount of the onium salt compound having formula (A1) and the photoacid generator added is at least 10 parts by weight per 80 parts by weight of the polymer. As long as the amounts of the photoacid generator and the onium salt compound added are in the above-defined ranges, and the weight ratio of the photoacid generator to the onium salt compound is less than 4, a multiplicity of points of acid generation are available in the exposed region and acid diffusion is further suppressed, achieving further improved resolution and CDU.

### (B) Base polymer

Component (B) is a base polymer which contains a polymer comprising repeat units having the formula (B1), which are also referred to as repeat units B 1.

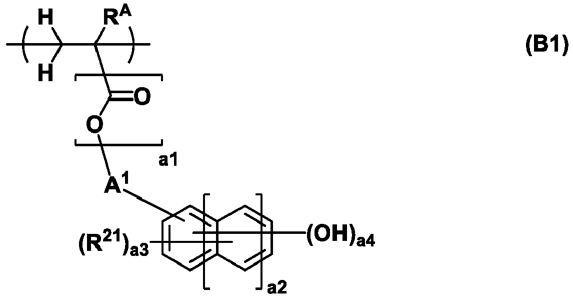

In formula (B1), R^{A} is hydrogen, fluorine, methyl or trifluoromethyl.

In formula (B1), a1 is 0 or 1. The subscript a2 is an integer of 0 to 2. The structure represents a benzene skeleton when a2=0, a naphthalene skeleton when a2=1, and an anthracene skeleton when a2=2. The subscript a3 is an integer meeting 0 ≤ a3 ≤ 5+2a2-a4. The subscript a4 is an integer of 1 to 3. When a2=0, preferably a3 is an integer of 0 to 3, and a4 is an integer of 1 to 3. When a2=1 or 2, preferably a3 is an integer of 0 to 4, and a4 is an integer of 1 to 3.

In formula (B1), R²¹ is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group. The saturated hydrocarbyl group and saturated hydrocarbyl moiety in the saturated hydrocarbylcarbonyloxy group and saturated hydrocarbyloxy group may be straight, branched or cyclic, and examples thereof include alkyl groups such as methyl, ethyl, n-propyl, isopropyl, butyl, pentyl, and hexyl, cycloalkyl groups such as cyclopropyl, cyclobutyl, cyclopentyl and cyclohexyl, and combinations thereof. A carbon count within the upper limit ensures good solubility in alkaline developer. Groups R²¹ may be identical or different when a3 is 2 or more.

In formula (B 1), A¹ is a single bond or a C₁-C₁₀ saturated hydrocarbylene group in which any constituent -CH₂- may be replaced by -O-. The saturated hydrocarbylene group may be straight, branched or cyclic and examples thereof include alkanediyl groups such as methylene, ethane-1,2-diyl, propane-1,3-diyl, butane-1,4-diyl, pentane-1,5-diyl, hexane-1,6-diyl, and structural isomers thereof; cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case a1=1 in formula (B 1), the ether bond may be incorporated at any position excluding the position between the α-carbon and β-carbon relative to the ester oxygen. In case a1=0, the atom that bonds with the main chain becomes an ethereal oxygen, and a second ether bond may be incorporated at any position excluding the position between the α-carbon and β-carbon relative to that ethereal oxygen. Saturated hydrocarbylene groups having no more than 10 carbon atoms are desirable because of a sufficient solubility in alkaline developer.

In the embodiment wherein a1=0 and A¹ is a single bond, that is, the aromatic ring directly bonds to the polymer main chain, or differently stated, the unit is free of the linker (-C(=O)-O-A¹-), preferred examples of repeat units B 1 include units derived from 3-hydroxystyrene, 4-hydroxystyrene, 5-hydroxy-2-vinylnaphthalene and 6-hydroxy-2-vinylnaphthalene. Of repeat units B1, repeat units having the following formula (B 1-1) are preferred in view of better CDU. By incorporating repeat units having formula (B 1-1), the solubility of the exposed region of resist film in alkaline developer is improved, dimensional errors brought about by slightly different contact impacts of developer is mitigated, and better CDU is achieved. 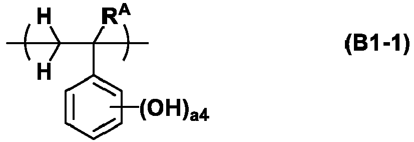 Herein R^{A} and a4 are as defined above.

In the embodiment wherein a1=1, that is, the unit has -C(=O)-O-A¹- as the linker, preferred examples of repeat unit B 1 are shown below, but not limited thereto. 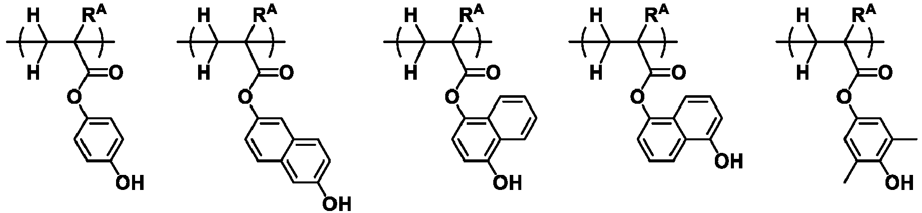 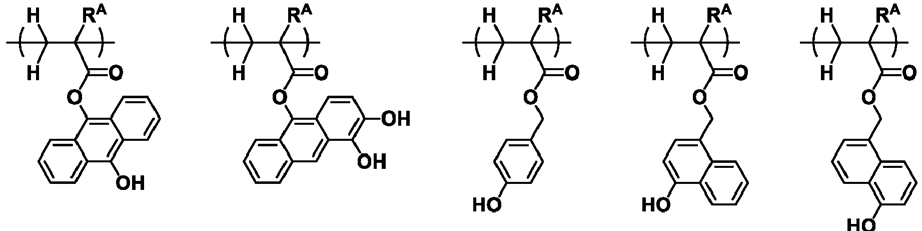 Herein R^{A} is as defined above.

The content of repeat units B1 is preferably 10 to 95 mol%, more preferably 40 to 90 mol% of the overall repeat units of the polymer. When the polymer further contains repeat units having formula (B3) and/or repeat units having formula (B4), which provide the polymer with higher etch resistance, the repeat units having a phenolic hydroxy group as a substituent, the content of repeat units B 1 and repeat units B3 and/or B4 is preferably in the range. The repeat units B1 may be used alone or in admixture of two or more.

In a preferred embodiment, the polymer further contains a unit having an acidic functional group protected with an acid labile group (i.e., unit protected with an acid labile group and adapted to turn alkali soluble under the action of acid) in order that the positive resist composition in an exposed region turn soluble in alkaline aqueous solution. In this embodiment, since the acid labile group (protective group) in the repeat unit undergoes deprotection reaction under the action of acid, the polymer becomes more soluble in alkaline developer.

Typical of the above unit is a unit having the formula (B2), also referred to as repeat unit B2.

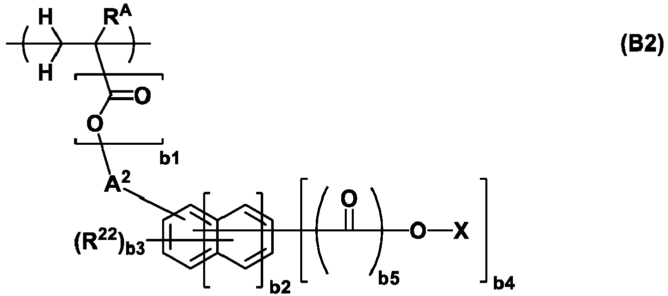

In formula (B2), R^{A} is as defined above. The subscript b1 is 0 or 1. The subscript b2 is an integer of 0 to 2. The structure represents a benzene skeleton when b2=0, a naphthalene skeleton when b2=1, and an anthracene skeleton when b2=2. The subscript b3 is an integer meeting 0 ≤ b3 ≤ 5+2b2-b4. The subscript b4 is an integer of 1 to 3, and b5 is 0 or 1. When b2=0, preferably b3 is an integer of 0 to 3, and b4 is an integer of 1 to 3. When b2=1 or 2, preferably b3 is an integer of 0 to 4, and b4 is an integer of 1 to 3.

In formula (B2), R²² is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group. The saturated hydrocarbyl group and saturated hydrocarbyl moiety in the saturated hydrocarbylcarbonyloxy group and saturated hydrocarbyloxy group may be straight, branched or cyclic, and examples thereof include alkyl groups such as methyl, ethyl, n-propyl, isopropyl, butyl, pentyl, and hexyl, cycloalkyl groups such as cyclopropyl, cyclobutyl, cyclopentyl and cyclohexyl, and combinations thereof. A carbon count within the upper limit ensures good solubility in alkaline developer. Groups R²² may be identical or different when b3 is 2 or more.

In formula (B2), A² is a single bond or a C₁-C₁₀ saturated hydrocarbylene group in which any constituent -CH₂- may be replaced by -O-. The saturated hydrocarbylene group may be straight, branched or cyclic and examples thereof include alkanediyl groups such as methylene, ethane-1,2-diyl, propane-1,3-diyl, butane-1,4-diyl, pentane-1,5-diyl, hexane-1,6-diyl, and structural isomers thereof; cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case b1=1 in formula (B2), the ether bond may be incorporated at any position excluding the position between the α-carbon and β-carbon relative to the ester oxygen. In case b1=0, the atom that bonds with the main chain becomes an ethereal oxygen, and a second ether bond may be incorporated at any position excluding the position between the α-carbon and β-carbon relative to that ethereal oxygen. Saturated hydrocarbylene groups having no more than 10 carbon atoms are desirable because of a sufficient solubility in alkaline developer.

In formula (B2), X is an acid labile group when b4=1, and hydrogen or an acid labile group, at least one X being an acid labile group, when b4=2 or 3. That is, repeat units B2 have phenolic hydroxy groups bonded to an aromatic ring, at least one of which is protected with an acid labile group, or repeat units B2 have a carboxy group bonded to an aromatic ring, which is protected with an acid labile group. The acid labile group used herein is not particularly limited as long as it is commonly used in a number of well-known chemically amplified resist compositions and eliminated under the action of acid to release an acidic group.

It is preferred that a tertiary saturated hydrocarbyl group is selected as the acid labile group, for the reason that when a resist film is formed to a thickness of 10 to 100 nm and processed to form a small size pattern having a line width of up to 45 nm, the pattern has reduced LER. The tertiary saturated hydrocarbyl group is preferably of 4 to 18 carbon atoms because a monomer for use in polymerization is recoverable by distillation. The group bonded to the tertiary carbon atom in the tertiary saturated hydrocarbyl group is typically a C₁-C₁₅ saturated hydrocarbyl group which may contain an oxygen-containing functional group such as an ether bond or carbonyl group. The groups bonded to the tertiary carbon atom may bond together to form a ring.

Examples of the group bonded to the tertiary carbon atom include methyl, ethyl, propyl, adamantyl, norbornyl, tetrahydrofuran-2-yl, 7-oxanorbornan-2-yl, cyclopentyl, 2-tetrahydrofuryl, tricyclo[5.2.1.0^{2,6}]decyl, tetracyclo[4.4.0.1^{2,5}.1^{7,10}]dodecyl, and 3-oxo-1-cyclohexyl.

Examples of the tertiary saturated hydrocarbyl group having such a substituent include, but are not limited to, tert-butyl, tert-pentyl, 1-ethyl-1-methylpropyl, 1,1-diethylpropyl, 1,1,2-trimethylpropyl, 1-adamantyl-1-methylethyl, 1-methyl-1-(2-norbornyl)ethyl, 1-methyl-1-(tetrahydrofuran-2-yl)ethyl, 1-methyl-1-(7-oxanorbornan-2-yl)ethyl, 1-methylcyclopentyl, 1-ethylcyclopentyl, 1-propylcyclopentyl, 1-isopropylcyclopentyl, 1-cyclopentylcyclopentyl, 1-cyclohexylcyclopentyl, 1-(2-tetrahydrofuryl)cyclopentyl, 1-(7-oxanorbornan-2-yl)cyclopentyl, 1-methylcyclohexyl, 1-ethylcyclohexyl, 1-cyclopentylcyclohexyl, 1-cyclohexylcyclohexyl, 2-methyl-2-norbornyl, 2-ethyl-2-norbornyl, 8-methyl-8-tricyclo[5.2.1.0^{2,6}]decyl, 8-ethyl-8-tricyclo[5.2.1.0^{2,6}]decyl, 3-methyl-3-tetracyclo[4.4.0.1^{2,5}.1^{7,10}]dodecyl, 3-ethyl-3-tetracyclo[4.4.0.1^{2,5}.1^{7,10}]dodecyl, 2-methyl-2-adamantyl, 2-ethyl-2-adamantyl, 1-methyl-3-oxo-1-cyclohexyl, 1-methyl-1-(tetrahydrofuran-2-yl)ethyl, 5-hydroxy-2-methyl-2-adamantyl, and 5-hydroxy-2-ethyl-2-adamantyl.

A group having the following formula (B2-1) is also suitable as the acid labile group. The group having formula (B2-1) is often used as the acid labile group. It is a good choice of the acid labile group that ensures to form a pattern having a substantially rectangular pattern-substrate interface in a consistent manner. An acetal structure is formed when X is a group having formula (B2-1).

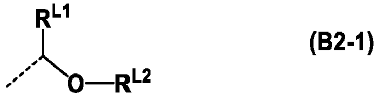

In formula (B2-1), R^{L1} is hydrogen or a C₁-C₁₀ saturated hydrocarbyl group. R^{L2} is a C₁-C₃₀ saturated hydrocarbyl group. The saturated hydrocarbyl group may be straight, branched or cyclic. A choice of R^{L1} may depend on the designed sensitivity of labile group to acid. For example, hydrogen is selected when the acid labile group is designed to ensure relatively high stability and to be decomposed with strong acid. A straight alkyl group is selected when the acid labile group is designed to have relatively high reactivity and high sensitivity to pH changes. Although the choice varies with a particular combination of acid generator and basic compound in the resist composition, R^{L1} is preferably a group in which the carbon in bond with acetal carbon is secondary, when R^{L2} is a relatively large alkyl group substituted at the end and the acid labile group is designed to undergo a substantial change of solubility by decomposition. Examples of R^{L1} bonded to acetal carbon via secondary carbon include isopropyl, sec-butyl, cyclopentyl, and cyclohexyl.

In the acetal group, R^{L2} is preferably a C₇-C₃₀ polycyclic alkyl group for acquiring a higher resolution. When R^{L2} is a polycyclic alkyl group, a bond is preferably formed between secondary carbon on the polycyclic structure and acetal oxygen. The acetal oxygen bonded to secondary carbon on the cyclic structure, as compared with the acetal oxygen bonded to tertiary carbon on the cyclic structure, ensures that a corresponding polymer becomes a stable compound, suggesting that the resist composition has better shelf stability and is not degraded in resolution. Said acetal oxygen, as compared with R^{L2} bonded to primary carbon via a straight alkyl group of at least one carbon atom, ensures that a corresponding polymer has a higher glass transition temperature (Tg), suggesting that a resist pattern after development is not deformed by bake.

Preferred examples of the group having formula (B2-1) are given below, but not limited thereto. Herein R^{L1} is as defined above.

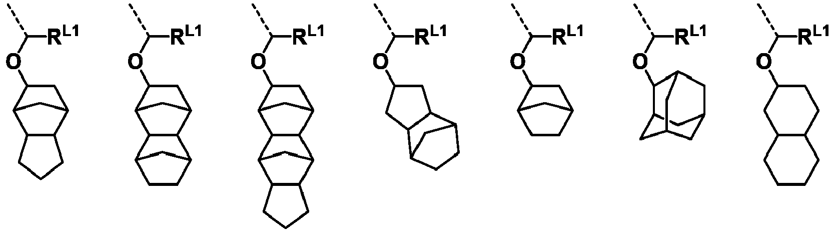

Another choice of acid labile group is a phenolic hydroxy group having hydrogen substituted by -CH₂COO- (tertiary saturated hydrocarbyl group). The tertiary saturated hydrocarbyl group used herein may be the same as the aforementioned tertiary saturated hydrocarbyl groups used for the protection of phenolic hydroxy group.

The content of repeat units B2 is preferably 5 to 45 mol% of the overall repeat units of the polymer. The repeat units B2 may be of one type or a mixture of two or more types.

In a preferred embodiment, the polymer further comprises repeat units of at least one type selected from units having the formulae (B3), (B4) and (B5). These repeat units are simply referred to as repeat units B3, B4 and B5, respectively.

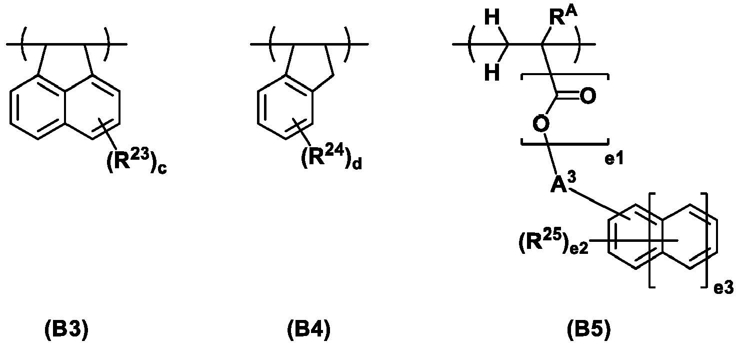

In formulae (B3) and (B4), c and d are each independently an integer of 0 to 4.

In formulae (B3) and (B4), R²³ and R²⁴ are each independently hydroxy, halogen, an optionally halogenated C₂-C₈ saturated hydrocarbylcarbonyloxy group, optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group. The saturated hydrocarbyl group, saturated hydrocarbyloxy group and saturated hydrocarbylcarbonyloxy group may be straight, branched or cyclic. When c is 2 or more, a plurality of groups R²³ may be identical or different. When d is 2 or more, a plurality of groups R²⁴ may be identical or different.

In formula (B5), e1 is 0 or 1. The subscript e2 is an integer of 0 to 5. The subscript e3 is an integer of 0 to 2. The structure represents a benzene skeleton when e3=0, a naphthalene skeleton when e3=1, and an anthracene skeleton when e3=2. When e3=0, preferably e2 is an integer of 0 to 3. When e3=1 or 2, preferably e2 is an integer of 0 to 4.

In formula (B5), R^{A} is as defined above. R²⁵ is an acetyl group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen atom, nitro group, cyano group, sulfinyl group or sulfonyl group. The saturated hydrocarbyl group, saturated hydrocarbyloxy group, saturated hydrocarbylcarbonyloxy group, saturated hydrocarbyloxyhydrocarbyl group, and saturated hydrocarbylthiohydrocarbyl group may be straight, branched or cyclic. When e2 is 2 or more, a plurality of groups R²⁵ may be identical or different.

R²⁵ is preferably selected from halogen atoms such as chlorine, bromine, and iodine, saturated hydrocarbyl groups such as methyl, ethyl, propyl, butyl, pentyl, hexyl, cyclopentyl, cyclohexyl, and structural isomers thereof, and saturated hydrocarbyloxy groups such as methoxy, ethoxy, propoxy, butoxy, pentyloxy, hexyloxy, cyclopentyloxy, cyclohexyloxy, and structural isomers of their hydrocarbon moiety. Inter alia, methoxy and ethoxy are useful.

Also, a saturated hydrocarbylcarbonyloxy group may be introduced into a polymer even at the end of polymerization by the chemical modification method and is thus advantageously used for fine adjustment of solubility of a base polymer in alkaline developer. Suitable saturated hydrocarbylcarbonyloxy groups include methylcarbonyloxy, ethylcarbonyloxy, propylcarbonyloxy, butylcarbonyloxy, pentylcarbonyloxy, hexylcarbonyloxy, cyclopentylcarbonyloxy, cyclohexylcarbonyloxy, benzoyloxy, and structural isomers of their hydrocarbon moiety. As long as the carbon count is not more than 20, the group is effective for appropriately controlling and adjusting (typically reducing) the solubility of a base polymer in alkaline developer and for preventing scum or development defects from forming.

Of the preferred substituent groups mentioned above, chlorine, bromine, iodine, methyl, ethyl, and methoxy are especially useful because corresponding monomers are readily furnished.

In formula (B5), A³ is a single bond or a C₁-C₁₀ saturated hydrocarbylene group in which any constituent -CH₂- may be replaced by -O-. The saturated hydrocarbylene group may be straight, branched or cyclic. Examples thereof include alkanediyl groups such as methylene, ethane-1,2-diyl, propane-1,3-diyl, butane-1,4-diyl, pentane-1,5-diyl, hexane-1,6-diyl, and structural isomers thereof, cyclic saturated hydrocarbylene groups such as cyclopropanediyl, cyclobutanediyl, cyclopentanediyl, and cyclohexanediyl, and combinations thereof. For the saturated hydrocarbylene group containing an ether bond, in case of e1=1 in formula (B5), the ether bond may be incorporated at any position excluding the position between the α-carbon and β-carbon relative to the ester oxygen. In case of e1=0, the atom bonding to the backbone becomes an ethereal oxygen atom, and a second ether bond may be incorporated at any position excluding the position between the α-carbon and β-carbon relative to the ethereal oxygen. Saturated hydrocarbylene groups having no more than 10 carbon atoms are desirable because of a sufficient solubility in alkaline developer.

Preferred examples of the repeat units B5 wherein e1=0 and A³ is a single bond (meaning that the aromatic ring is directly bonded to the main chain of the polymer), that is, repeat units free of a linker: -C(=O)-O-A³- include units derived from styrene, 4-chlorostyrene, 4-bromostyrene, 4-methylstyrene, 4-methoxystyrene, 4-acetoxystyrene, 2-hydroxypropylstyrene, 2-vinylnaphthalene, and 3-vinylnaphthalene.

Preferred examples of the repeat units B5 wherein e1=1, that is, having a linker: - C(=O)-O-A³- are shown below, but not limited thereto. Herein R^{A} is as defined above.

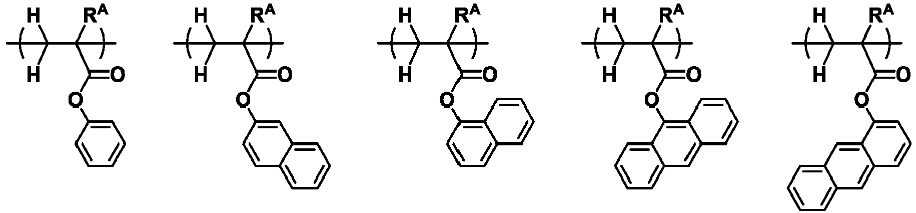

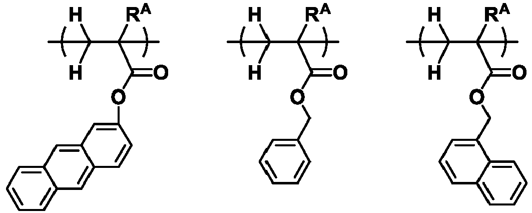

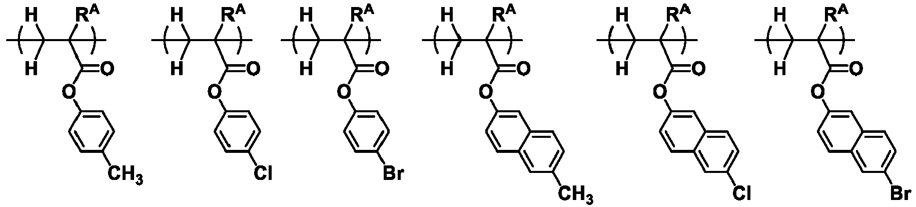

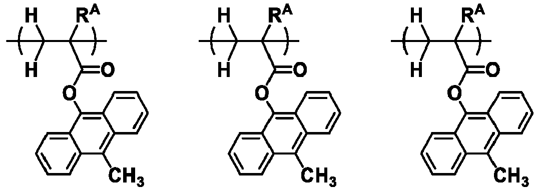

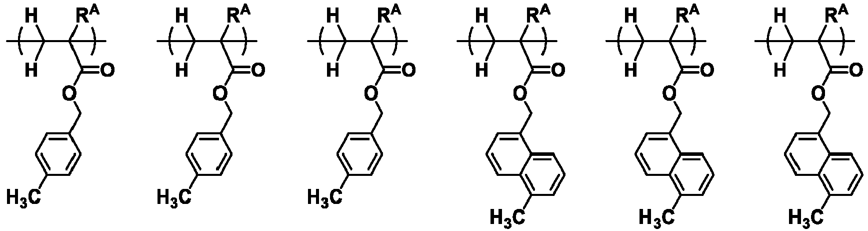

When repeat units of at least one type selected from repeat units B3 to B5 are incorporated, better performance is obtained because not only the aromatic ring possesses etch resistance, but the cyclic structure incorporated into the main chain also exerts the effect of improving etch resistance and resistance to EB irradiation during pattern inspection step.

The content of repeat units B3 to B5 is preferably at least 5 mol% based on the overall repeat units of the polymer for obtaining the effect of improving etch resistance. Also, the content of repeat units B3 to B5 is preferably up to 35 mol%, more preferably up to 30 mol% based on the overall repeat units of the polymer. When the relevant units are free of functional groups or have a functional group other than the aforementioned ones, their content of up to 35 mol% is preferred because the risk of forming development defects is eliminated. Each of the repeat units B3 to B5 may be of one type or a combination of plural types.

It is preferred that the polymer comprise repeat units B 1, repeat units B2, and repeat units of at least one type selected from repeat units B3 to B5, because both etch resistance and high resolution are achievable. The total content of these repeat units is preferably at least 60 mol%, more preferably at least 70 mol%, even more preferably at least 80 mol% based on the overall repeat units of the polymer.

In another preferred embodiment, the polymer further comprises repeat units of at least one type selected from repeat units having the formula (B6), repeat units having the formula (B7), repeat units having the formula (B8), repeat units having the formula (B9), repeat units having the formula (B10), repeat units having the formula (B 11), repeat units having the formula (B12), and repeat units having the formula (B13), shown below. Notably these repeat units are also referred to as repeat units B6 to B 13. This embodiment achieves effective control of acid diffusion, and forms a pattern with an improved resolution and a reduced LER.

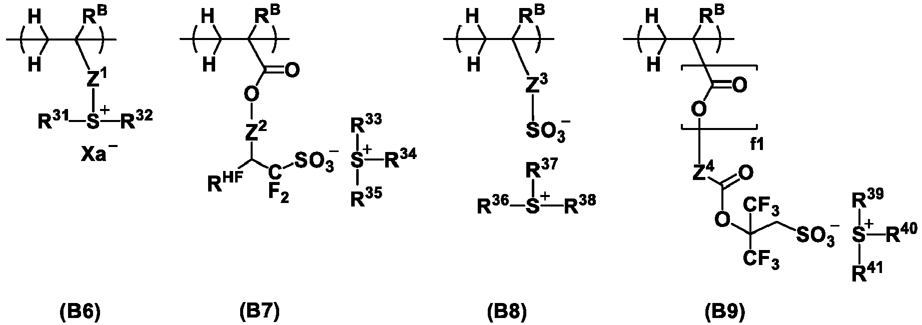

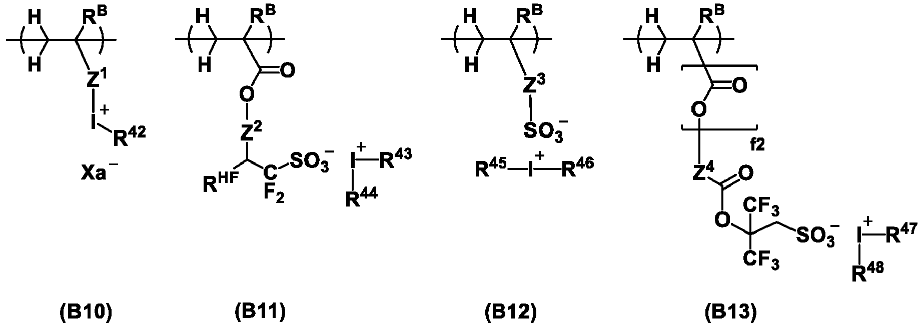

In formulae (B6) to (B13), R^{B} is each independently hydrogen or methyl. Z¹ is a single bond, a C₁-C₆ aliphatic hydrocarbylene group, phenylene group, naphthylene group or C₇-C₁₈ group obtained by combining the foregoing, -O-Z¹¹-, -C(=O)-O-Z¹¹-, or -C(=O)-NH-Z¹¹-, wherein Z¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety. Z² is a single bond or -Z²¹-C(=O)-O-, wherein Z²¹ is a C₁-C₂₀ hydrocarbylene group which may contain a heteroatom. Z³ is a single bond, methylene, ethylene, phenylene, fluorinated phenylene, trifluoromethyl-substituted phenylene, -O-Z³¹-, -C(=O)-O-Z³¹-, or -C(=O)-NH-Z³¹-, wherein Z³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety. Z⁴ is a single bond or C₁-C₃₀ hydrocarbylene group which may contain a heteroatom, f1 and f2 are each independently 0 or 1, f1 and f2 are 0 when Z⁴ is a single bond.

In formulae (B7) and (B11) wherein Z² is -Z²¹-C(=O)-O-, Z²¹ is a hydrocarbylene group which may contain a heteroatom. Illustrative, non-limiting examples of the hydrocarbylene group Z²¹ are given below.

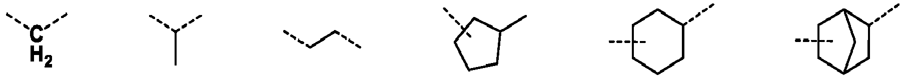

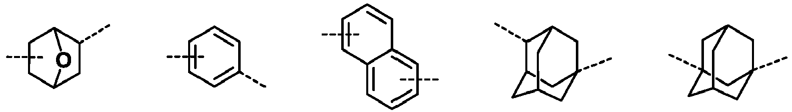

In formulae (B7) and (B11), R^{HF} is hydrogen or trifluoromethyl. Examples of the repeat units B7 and B11 wherein R^{HF} is hydrogen are as described in JP-A 2010-116550. Examples of the repeat units B7 and B11 wherein R^{HF} is trifluoromethyl are as described in JP-A 2010-077404. Examples of the repeat units B8 and B12 are as described in JP-A 2012-246265 and JP-A 2012-246426.

In formulae (B6) and (B10), Xa⁻ is a non-nucleophilic counter ion. Examples of the non-nucleophilic counter ion Xa⁻ are as described in JP-A 2010-113209 and JP-A 2007-145797.

Preferred examples of the anion in the monomer from which repeat units B9 and B13 are derived are shown below, but not limited thereto.

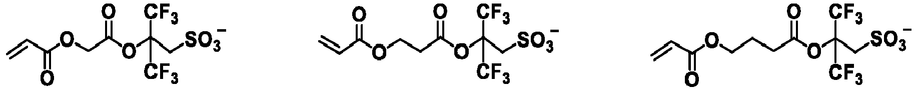

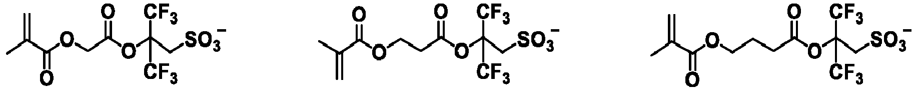

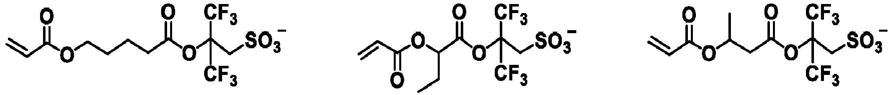

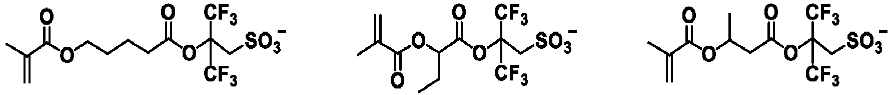

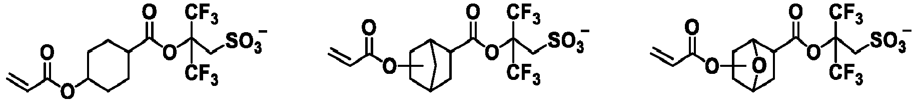

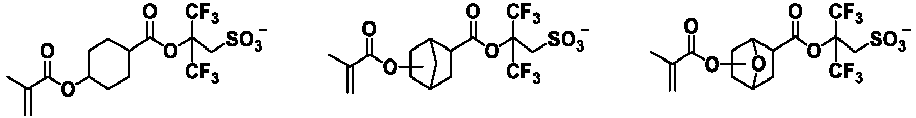

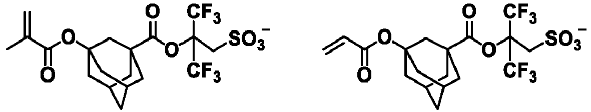

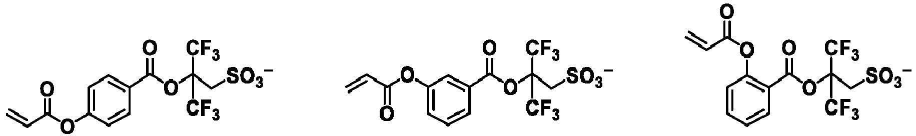

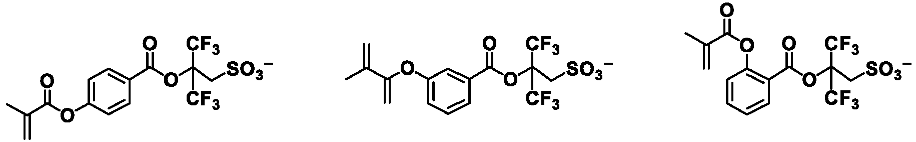

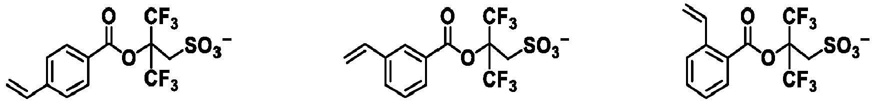

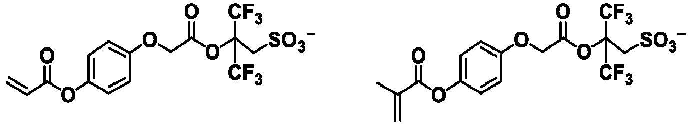

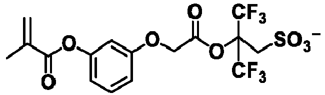

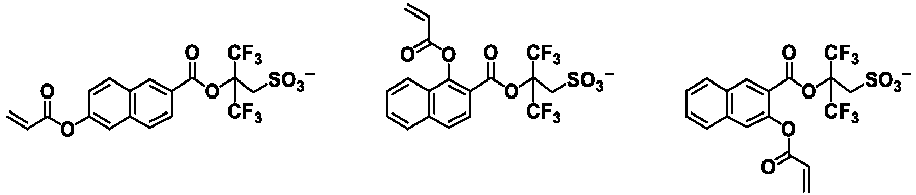

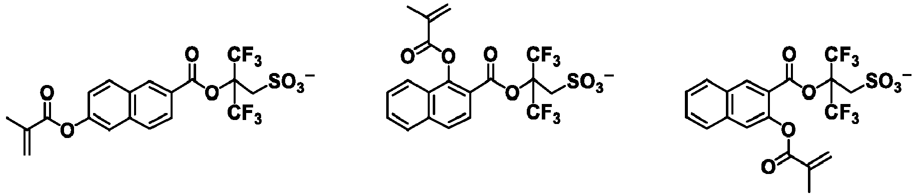

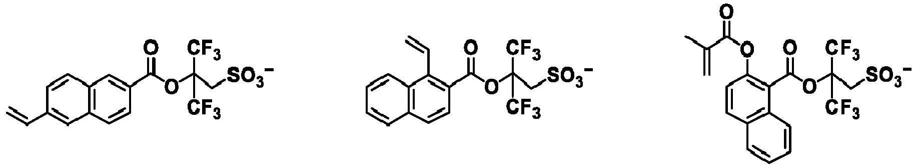

In formulae (B6) to (B13), R³¹ to R⁴⁸ are each independently a C₁-C₂₀ hydrocarbyl group which may contain a heteroatom. The hydrocarbyl group may be saturated or unsaturated and straight, branched or cyclic. Examples thereof are as exemplified above for the hydrocarbyl groups R¹ to R¹⁰ in formula (A1). In these hydrocarbyl groups, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy, fluorine, chlorine, bromine, iodine, cyano, nitro, carbonyl, ether bond, ester bond, sulfonic ester bond, carbonate bond, lactone ring, sultone ring, carboxylic anhydride (-C(=O)-O-C(=O)-) or haloalkyl moiety.

A pair of R³¹ and R³² may bond together to form a ring with the sulfur atom to which they are attached. A pair of R³³ and R³⁴, R³⁶ and R³⁷, or R³⁹ and R⁴⁰ may bond together to form a ring with the sulfur atom to which they are attached. Examples of the ring are shown below.

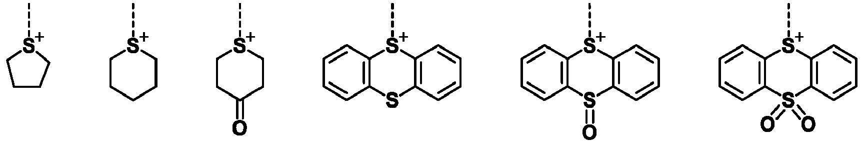

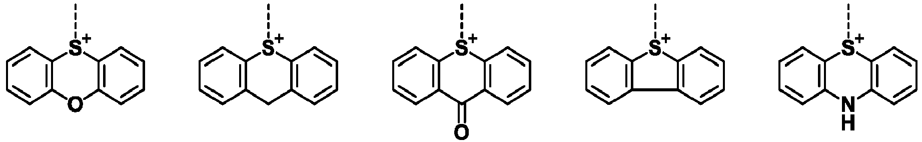

Exemplary structures of the sulfonium cation in formulae (B7) to (B9) are shown below, but not limited thereto.

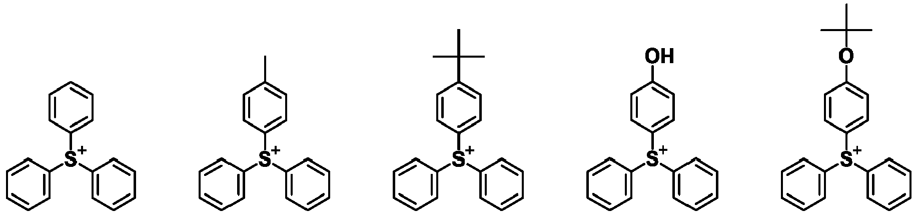

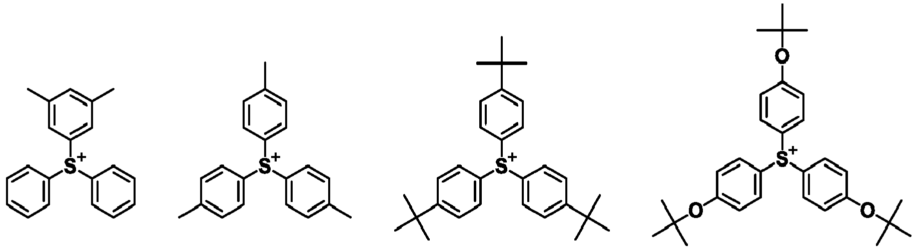

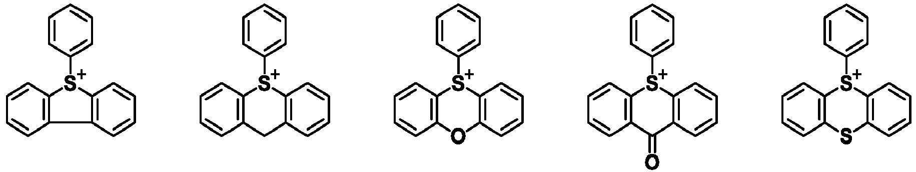

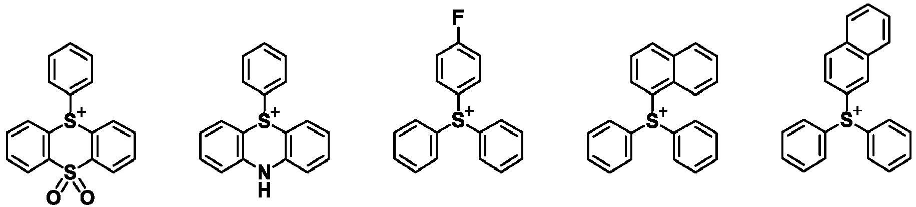

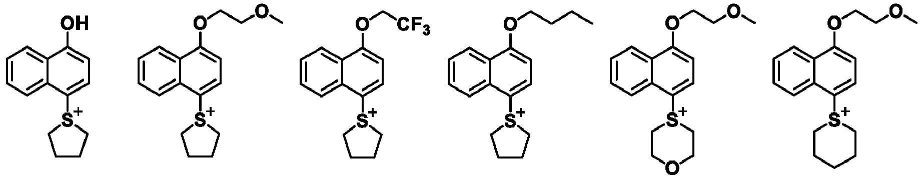

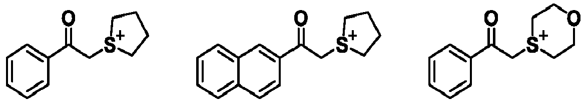

Exemplary structures of the iodonium cation in formulae (B 11) to (B 13) are shown below, but not limited thereto.

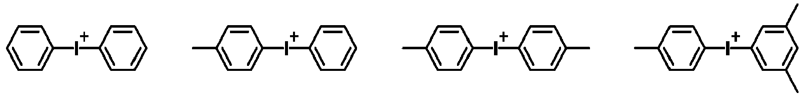

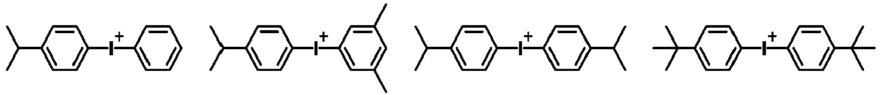

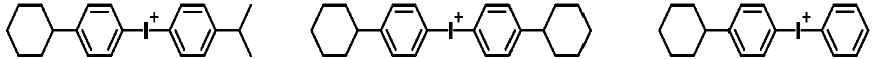

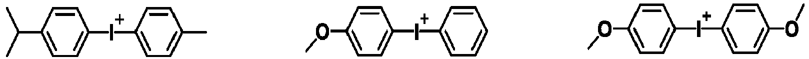

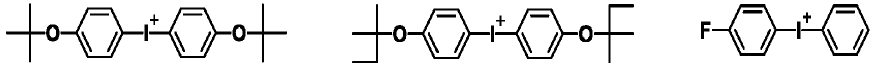

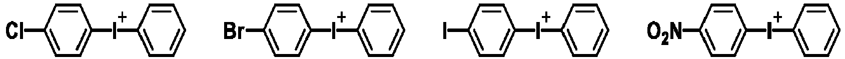

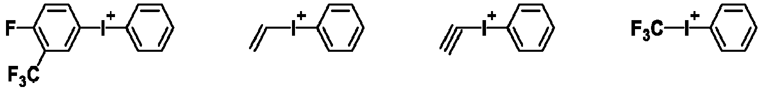

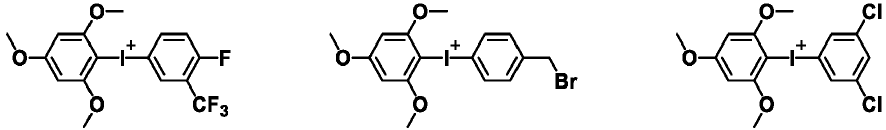

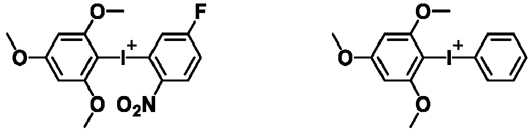

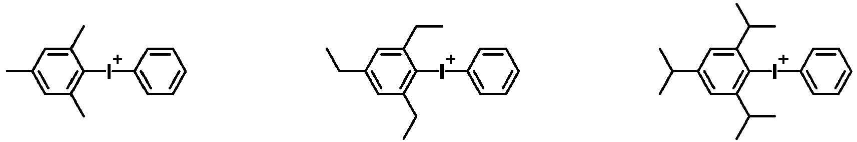

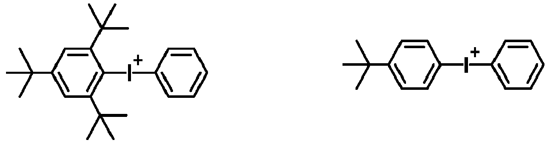

The repeat units B6 to B 13 are capable of generating an acid upon receipt of high-energy radiation. With these units bound to a polymer, an appropriate control of acid diffusion becomes possible, and a pattern with reduced LER and improved CDU can be formed. Since the acid-generating unit is bound to a polymer, the chemical flare phenomenon that acid volatilizes from the exposed region and re-deposits on the unexposed region during bake in vacuum is suppressed. This is effective for improving LER and CDU and for suppressing unwanted deprotection reaction in the unexposed region for thereby reducing pattern defects. When the repeat units B6 to B 13 are included, their content is preferably 0.5 to 30 mol% based on the overall repeat units of the polymer. Each of the repeat units B6 to B 13 may be of one type or a combination of plural types.

The base polymer (B) may be a mixture of a first polymer comprising repeat units B 1 and one or more of repeat units B6 to B 13 and a second polymer comprising repeat units B 1, but not repeat units B6 to B 13. In the mixture, the amount of the second polymer not containing repeat units B6 to B 13 is preferably 2 to 5,000 parts by weight, more preferably 10 to 1,000 parts by weight per 100 parts by weight of the first polymer containing repeat units B6 to B 13.

The content of repeat units having an aromatic skeleton is preferably at least 65 mol%, more preferably at least 85 mol% of the overall repeat units of the polymer in the base polymer. Most preferably all units are repeat units having an aromatic skeleton. Then the polymer is improved in polymerization uniformity and the resist film is improved in in-plane uniformity, both contributing to improved CDU.

As the base polymer, a polymer having a lactone functional group is known from Patent Document 8. The polymer having a lactone functional group is less lipophilic and invites a drop of alkaline developer resistance. This causes degradation of pattern profile and a lowering of CDU. In this context, it is preferred that the base polymer in the inventive resist composition does not contain a polymer having a lactone functional group.

The polymer may be synthesized, for example, by combining suitable monomers optionally protected with a protective group, copolymerizing them in the standard way, and effecting deprotection reaction if necessary. The copolymerization reaction is preferably radical polymerization or anionic polymerization though not limited thereto. For the polymerization reaction, reference may be made to JP-A 2004-115630, for example.

The polymer should preferably have a Mw of 1,000 to 50,000, and more preferably 2,000 to 20,000. A Mw of at least 1,000 eliminates the risk that pattern features are rounded at their top, inviting degradations of resolution, LER and CDU. A Mw of up to 50,000 eliminates the risk that LER and CDU are degraded when a pattern with a line width of up to 100 nm is formed. As used herein, Mw is measured by GPC versus polystyrene standards using tetrahydrofuran (THF) solvent.

The polymer preferably has a narrow molecular weight distribution or dispersity (Mw/Mn) of 1.0 to 2.0, more preferably 1.0 to 1.8. A polymer with such a narrow dispersity eliminates the risk that foreign particles are left on the pattern after development and the pattern profile is aggravated.

### (C) Photoacid generator

The chemically amplified positive resist composition further comprises (C) a photoacid generator (PAG), also referred to as acid generator of addition type. The PAG used herein may be any compound capable of generating an acid upon exposure to high-energy radiation. Suitable PAGs include sulfonium salts, iodonium salts, sulfonyldiazomethane, N-sulfonyloxyimide, and oxime-O-sulfonate acid generators.

Suitable PAGs include nonafluorobutane sulfonate, partially fluorinated sulfonates described in JP-A 2012-189977, paragraphs [0247]-[0251], partially fluorinated sulfonates described in JP-A 2013-101271, paragraphs [0261]-[0265], and those described in JP-A 2008-111103, paragraphs [0122]-[0142] and JP-A 2010-215608, paragraphs [0080]-[0081]. Among others, arylsulfonate and alkanesulfonate type PAGs are preferred because they generate acids having an appropriate strength to deprotect the acid labile group in the repeat units having formula (B2).

The preferred PAGs are compounds having a sulfonium anion of the structure shown below. Notably the cation that pairs with the anion is as exemplified for the sulfonium cation in formulae (B7) to (B9) and the iodonium cation in formulae (B 11) to (B13).

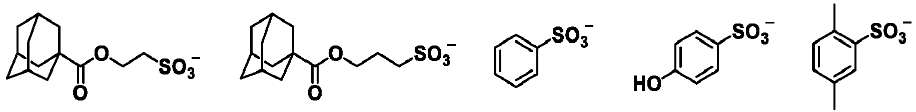

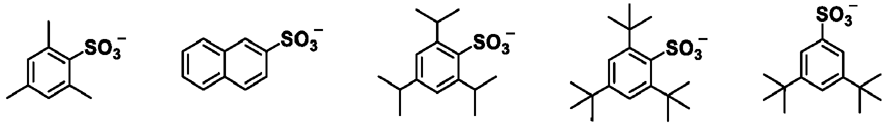

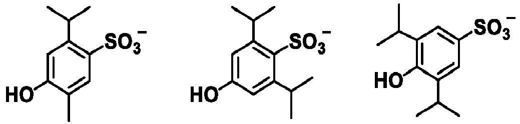

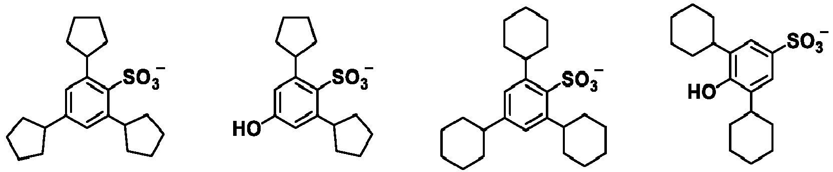

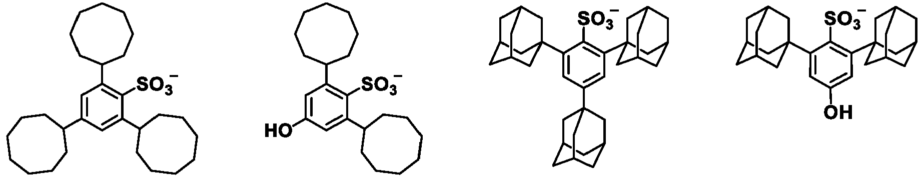

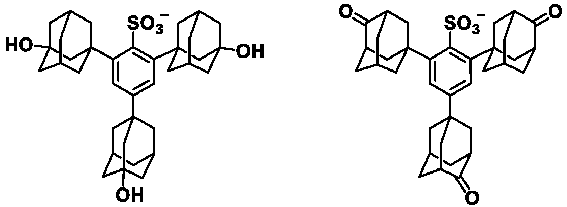

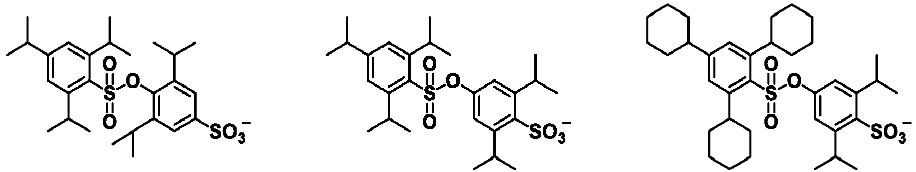

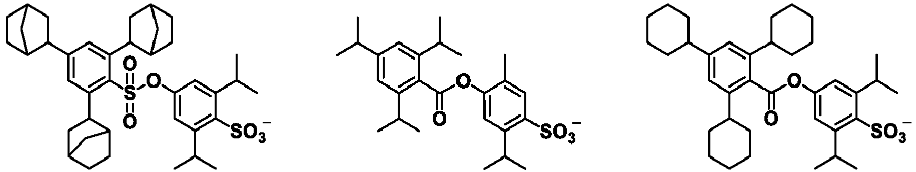

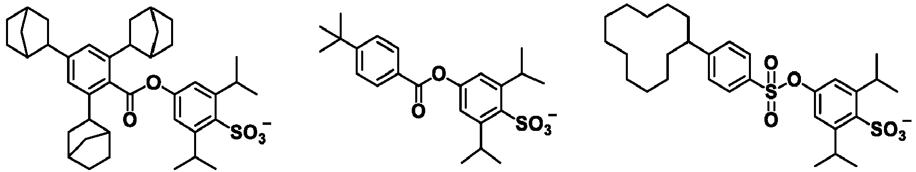

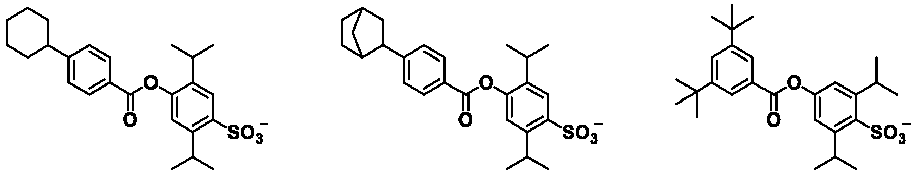

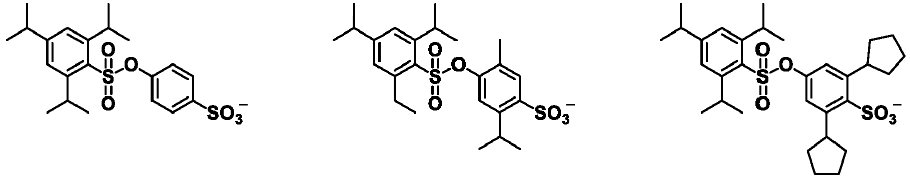

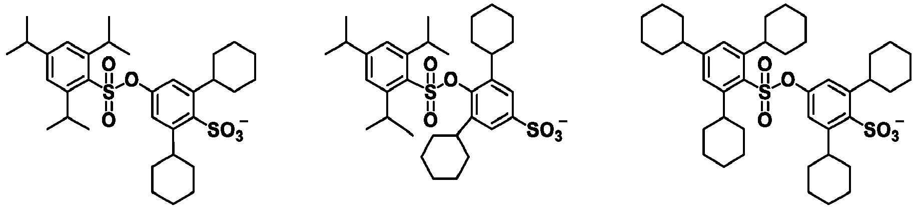

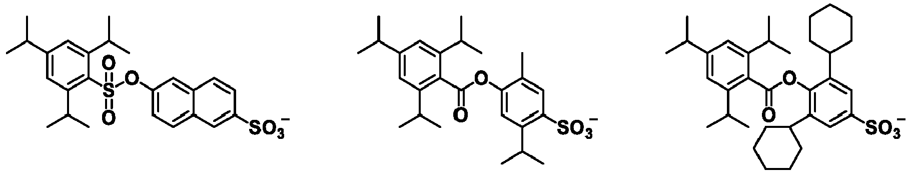

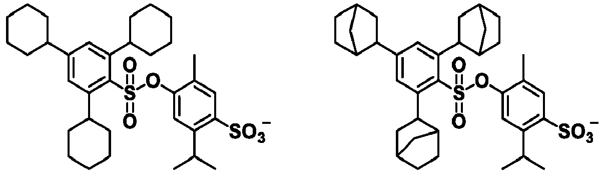

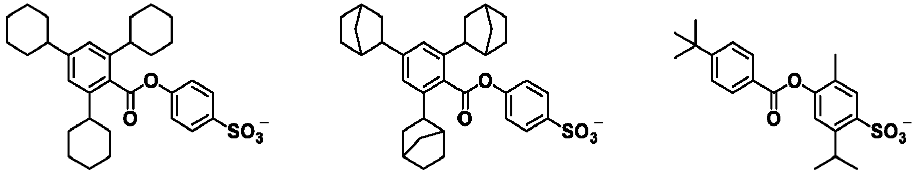

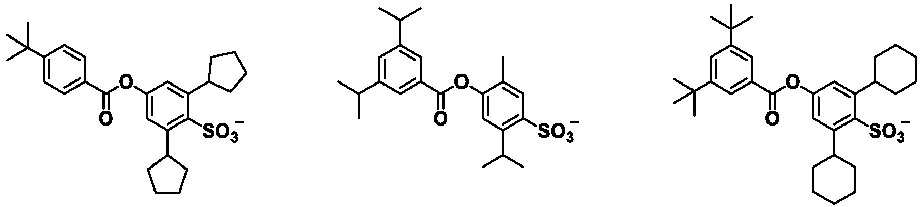

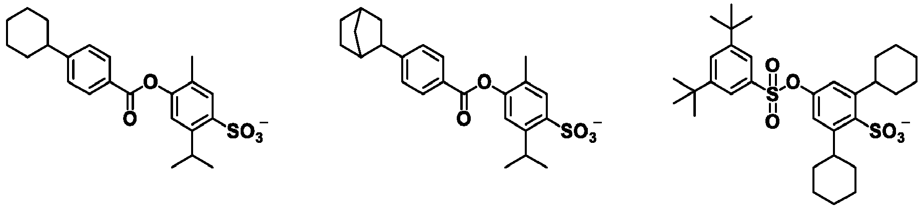

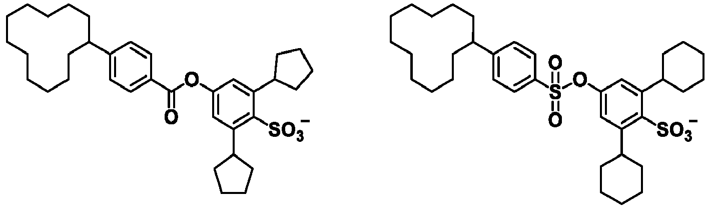

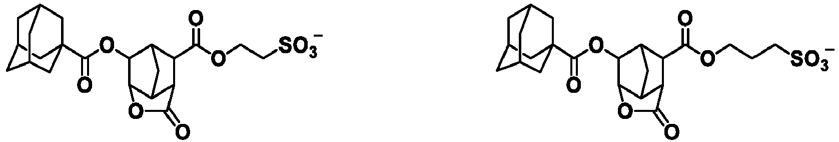

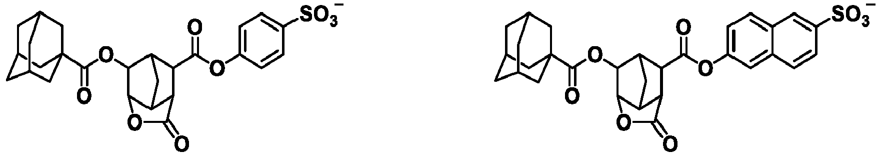

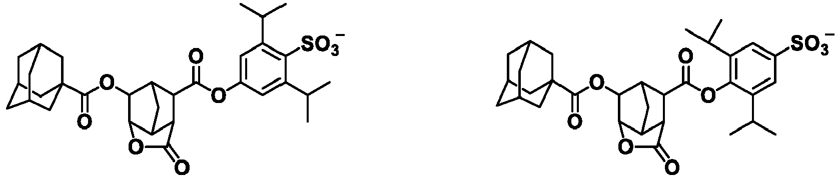

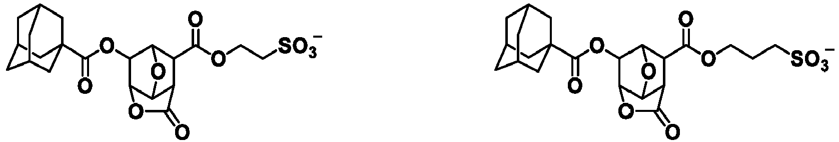

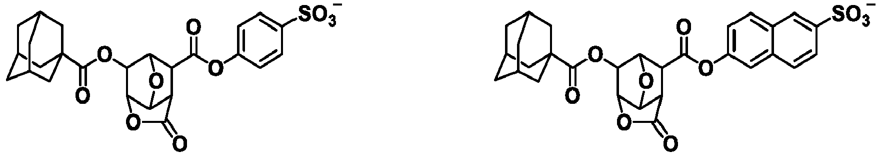

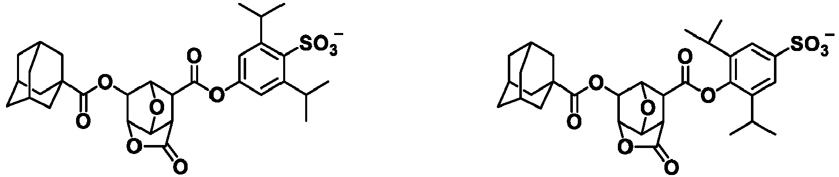

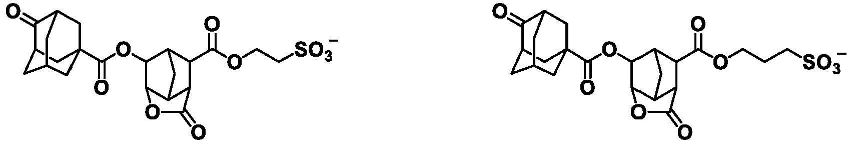

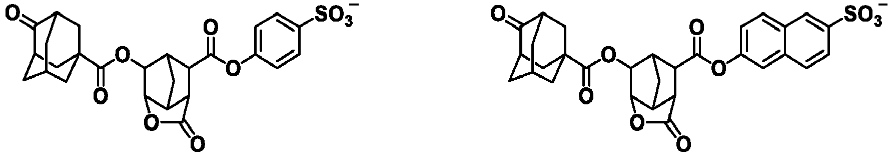

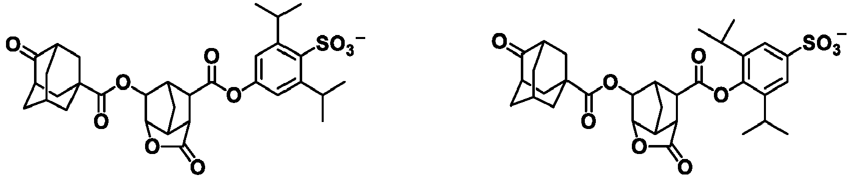

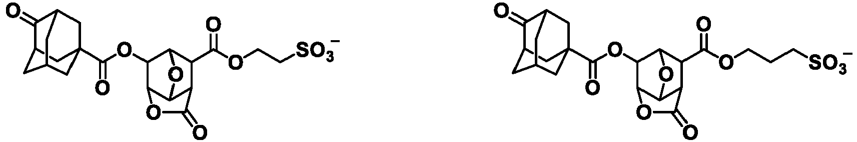

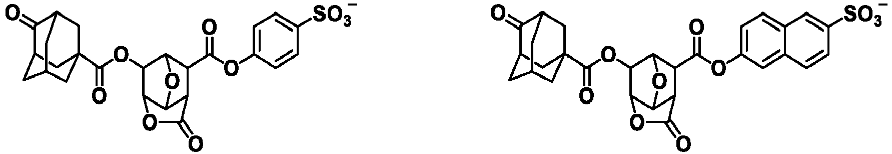

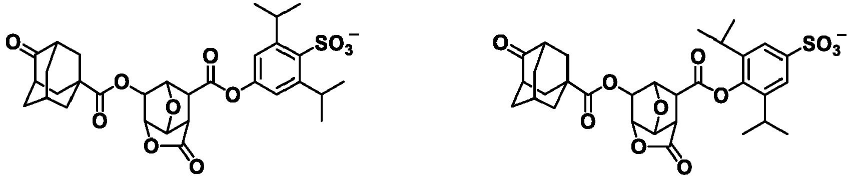

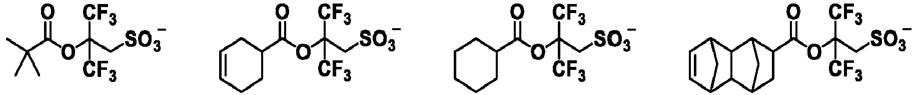

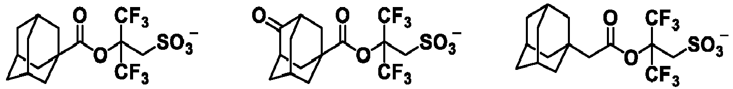

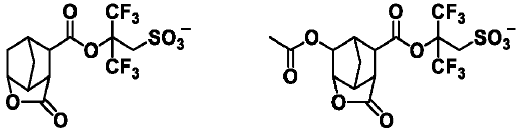

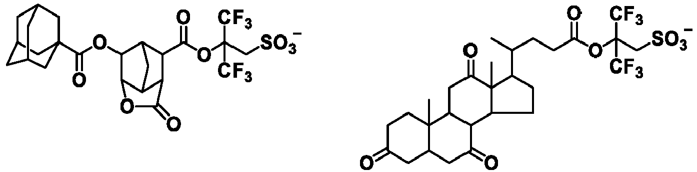

An appropriate amount of the photoacid generator of addition type (C) used is 5 to 30 parts, more preferably 5 to 20 parts by weight per 80 parts by weight of the base polymer (B). Where the base polymer contains repeat units B6 to B13 (that is, in the case of polymer-bound acid generator), the acid generator of addition type may be omitted. The photoacid generator may be used alone or in admixture.

### (D) Fluorinated polymer

The positive resist composition may further comprise (D) a fluorinated polymer comprising repeat units having the formula (D1) and repeat units of at least one type selected from repeat units having the formulae (D2), (D3), (D4), and (D5), for the purposes of enhancing contrast, preventing chemical flare of acid upon exposure to high-energy radiation, preventing mixing of acid from an anti-charging film in the step of coating an anti-charging film-forming material on a resist film, and suppressing unexpected unnecessary pattern degradation. Notably, repeat units having formulae (D1), (D2), (D3), (D4), and (D5) are simply referred to as repeat units D1, D2, D3, D4, and D5, respectively. Since the fluorinated polymer also has a surface active function, it can prevent insoluble residues from re-depositing onto the substrate during the development step and is thus effective for preventing development defects.

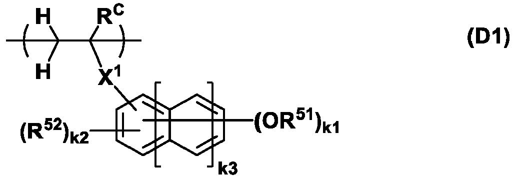

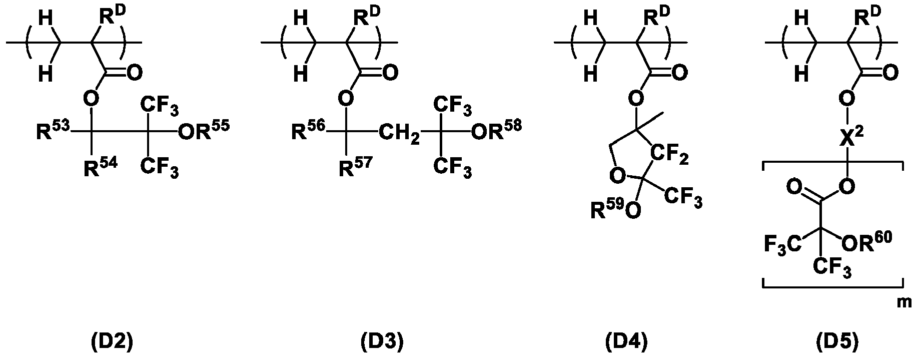

In formulae (D1) to (D5), R^{C} is each independently hydrogen or methyl. R^{D} is each independently hydrogen, fluorine, methyl or trifluoromethyl. R⁵¹ is hydrogen or a C₁-C₅ straight or branched hydrocarbyl group in which a heteroatom-containing moiety may intervene in a carbon-carbon bond. R⁵² is a C₁-C₅ straight or branched hydrocarbyl group in which a heteroatom-containing moiety may intervene in a carbon-carbon bond. R⁵³, R⁵⁴, R⁵⁶ and R⁵⁷ are each independently hydrogen or a C₁-C₁₀ saturated hydrocarbyl group. R⁵⁵, R⁵⁸, R⁵⁹ and R⁶⁰ are each independently hydrogen, a C₁-C₁₅ hydrocarbyl group or C₁-C₁₅ fluorinated hydrocarbyl group, or an acid labile group, with the proviso that an ether bond or carbonyl moiety may intervene in a carbon-carbon bond in the hydrocarbyl groups or fluorinated hydrocarbyl groups represented by R⁵⁵, R⁵⁸, R⁵⁹ and R⁶⁰. The subscript k1 is an integer of 1 to 3, k2 is an integer meeting: 0 ≤ k2 ≤ 5+2k3-k1, k3 is 0 or 1, and m is an integer of 1 to 3. X¹ is a single bond, -C(=O)-O- or -C(=O)-NH-. X² is a C₁-C₂₀ (m+1)-valent hydrocarbon group or C₁-C₂₀ (m+1)-valent fluorinated hydrocarbon group.

Examples of the C₁-C₅ hydrocarbyl groups R⁵¹ and R⁵² include alkyl, alkenyl and alkynyl groups, with the alkyl groups being preferred. Suitable alkyl groups include methyl, ethyl, n-propyl, isopropyl, n-butyl, isobutyl, sec-butyl, and n-pentyl. In these groups, a moiety containing a heteroatom such as oxygen, sulfur or nitrogen may intervene in a carbon-carbon bond.

In formula (D1), -OR⁵¹ is preferably a hydrophilic group. In this case, R⁵¹ is preferably hydrogen or a C₁-C₅ alkyl group in which oxygen intervenes in a carbon-carbon bond.

Examples of repeat unit D1 are given below, but not limited thereto. Herein R^{C} is as defined above.

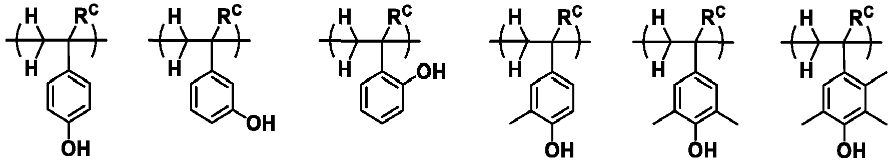

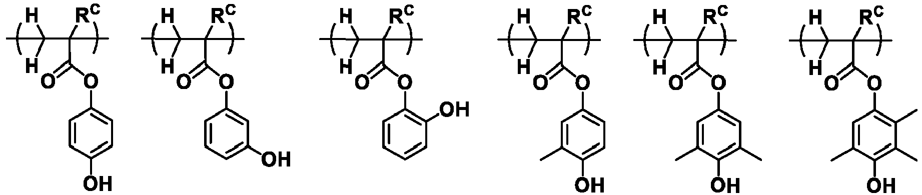

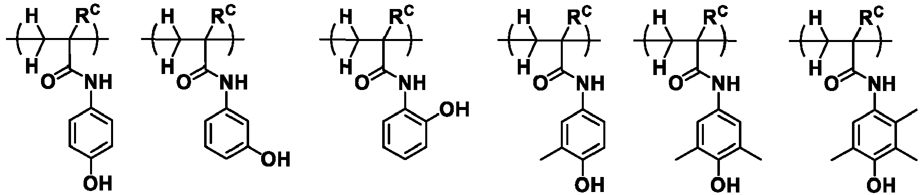

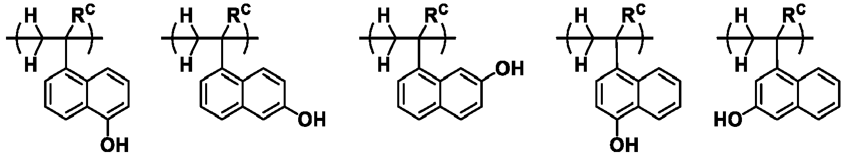

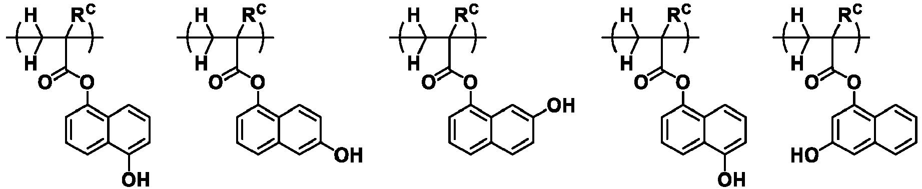

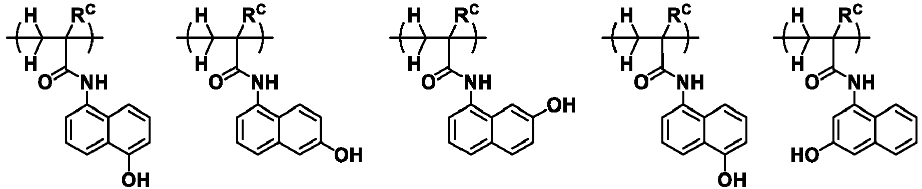

In formula (D1), X¹ is preferably -C(=O)-O- or -C(=O)-NH-. The inclusion of carbonyl in X¹ enhances the ability to trap the acid originating from the anti-charging film. Also preferably R^{C} is methyl. A polymer wherein R^{C} is methyl is a rigid polymer having a high glass transition temperature (Tg) which is effective for suppressing acid diffusion. As a result, the stability with time of a resist film is improved, and neither resolution nor pattern profile is degraded.

In formulae (D2) and (D3), examples of the C₁-C₁₀ saturated hydrocarbyl group represented by R⁵³, R⁵⁴, R⁵⁶ and R⁵⁷ include alkyl groups such as methyl, ethyl, n-propyl, isopropyl, n-butyl, isobutyl, sec-butyl, tert-butyl, n-pentyl, n-hexyl, n-heptyl, n-octyl, n-nonyl, and n-decyl, and cyclic saturated hydrocarbyl groups such as cyclopropyl, cyclobutyl, cyclopentyl, cyclohexyl, adamantyl, and norbornyl. Inter alia, C₁-C₆ saturated hydrocarbyl groups are preferred.

In formulae (D2) to (D5), examples of the C₁-C₁₅ hydrocarbyl group represented by R⁵⁵, R⁵⁸, R⁵⁹ and R⁶⁰ include alkyl, alkenyl and alkynyl groups, with the alkyl groups being preferred. Suitable alkyl groups include n-undecyl, n-dodecyl, tridecyl, tetradecyl and pentadecyl as well as those exemplified above. The fluorinated hydrocarbyl groups correspond to the foregoing hydrocarbyl groups in which some or all carbon-bonded hydrogen atoms are substituted by fluorine atoms.

Examples of the C₁-C₂₀ (m+1)-valent hydrocarbon group or fluorinated hydrocarbon group X² include the foregoing hydrocarbyl groups and fluorinated hydrocarbyl groups, with m number of hydrogen atoms being eliminated.

Examples of repeat units D2 to D5 are given below, but not limited thereto. Herein R^{D} is as defined above.

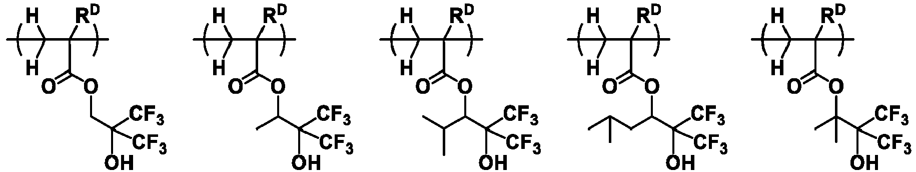

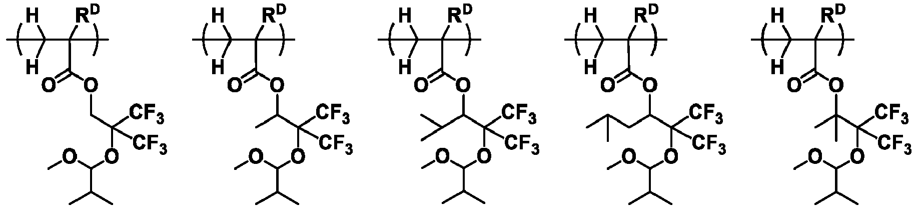

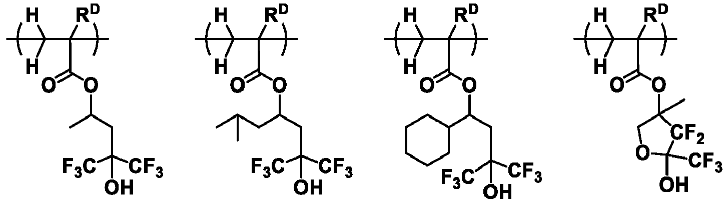

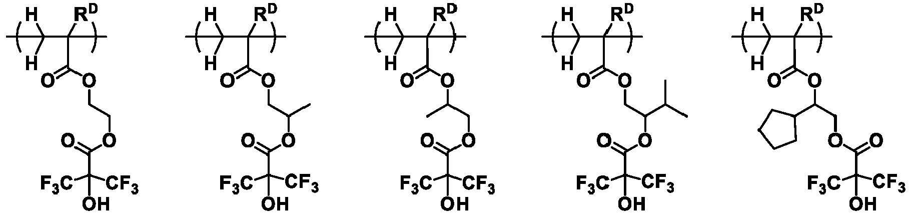

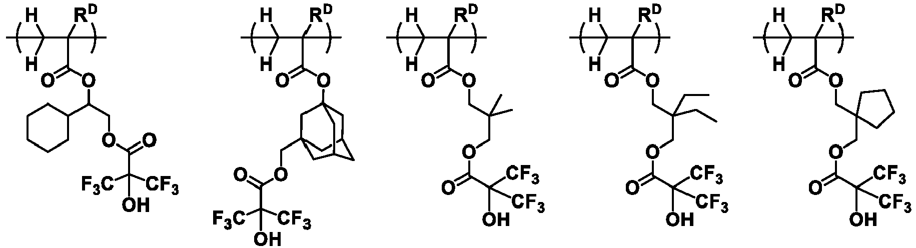

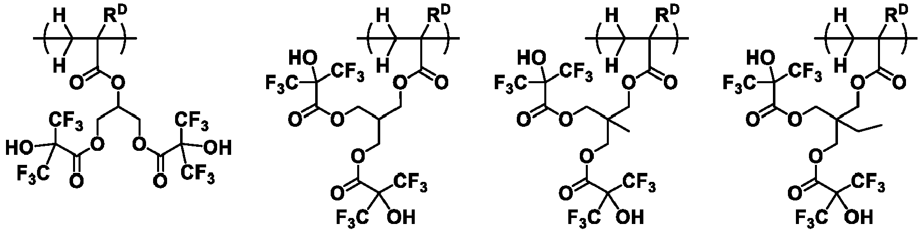

The repeat unit D1 is preferably incorporated in an amount of 5 to 85 mol%, more preferably 15 to 80 mol% based on the overall repeat units of the fluorinated polymer (D).

The repeat units D2 to D5 are preferably incorporated in an amount of 15 to 95 mol%, more preferably 20 to 85 mol% based on the overall repeat units of the fluorinated polymer (D). Each of repeat units D2 to D5 may be used alone or in admixture.

The fluorinated polymer (D) may comprise additional repeat units as well as the repeat units D1 to D5. Suitable additional repeat units include those described in USP 9,091,918 (JP-A 2014-177407, paragraphs [0046]-[0078]). When the fluorinated polymer (D) comprises additional repeat units, their content is preferably up to 50 mol% based on the overall repeat units.

The fluorinated polymer (D) may be synthesized, for example, by combining suitable monomers optionally protected with a protective group, copolymerizing them in the standard way, and effecting deprotection reaction if necessary. The copolymerization reaction is preferably radical polymerization or anionic polymerization though not limited thereto. For the polymerization reaction, reference may be made to JP-A 2004-115630.

The fluorinated polymer (D) should preferably have a Mw of 2,000 to 50,000, and more preferably 3,000 to 20,000. A fluorinated polymer with a Mw of less than 2,000 helps acid diffusion, degrading resolution and detracting from age stability. A polymer with too high Mw has a reduced solubility in solvent, with a risk of leaving coating defects. The fluorinated polymer preferably has a dispersity (Mw/Mn) of 1.0 to 2.2, more preferably 1.0 to 1.7.

In the positive resist composition, the fluorinated polymer (D) is preferably used in an amount of 0.01 to 30 parts, more preferably 0.1 to 20 parts by weight per 80 parts by weight of the base polymer (B). The fluorinated polymer (D) may be used alone or in admixture.

### (E) Organic solvent

The positive resist composition may further comprise (E) an organic solvent. The organic solvent used herein is not particularly limited as long as the components are soluble therein. Examples of the organic solvent are described in JP-A 2008-111103, paragraphs [0144] to [0145] (USP 7,537,880). Specifically, exemplary solvents include ketones such as cyclohexanone, cyclopentanone, methyl-2-n-pentyl ketone and 2-heptanone; alcohols such as 3-methoxybutanol, 3-methyl-3-methoxybutanol, 1-methoxy-2-propanol, 1-ethoxy-2-propanol, and diacetone alcohol; ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate (PGMEA), propylene glycol monoethyl ether acetate, ethyl lactate (EL), ethyl pyruvate, butyl acetate, methyl 3-methoxypropionate, ethyl 3-ethoxypropionate, t-butyl acetate, t-butyl propionate, and propylene glycol mono-t-butyl ether acetate; and lactones such as γ-butyrolactone (GBL), and mixtures thereof. Where an acid labile group of acetal form is used, a high-boiling alcohol solvent such as diethylene glycol, propylene glycol, glycerol, 1,4-butane diol or 1,3-butane diol may be added for accelerating deprotection reaction of acetal.

Of the above organic solvents, it is recommended to use 1-ethoxy-2-propanol, PGMEA, PGME, cyclohexanone, EL, GBL, and mixtures thereof.

In the positive resist composition, the organic solvent (E) is preferably used in an amount of 200 to 10,000 parts, more preferably 400 to 5,000 parts by weight per 80 parts by weight of the base polymer (B). The organic solvent (E) may be used alone or in admixture.

### (F) Basic compound

In the positive resist composition, (F) a basic compound may be added as the acid diffusion-controlling agent other than component (A) for the purpose of correcting a pattern profile or the like. The basic compound is effective for controlling acid diffusion. Even when the resist film is applied to a substrate having an outermost surface layer made of a chromium-containing material, the basic compound is effective for minimizing the influence of the acid generated in the resist film on the chromium-containing material.

Numerous basic compounds are known useful including primary, secondary, and tertiary aliphatic amines, mixed amines, aromatic amines, heterocyclic amines, nitrogen-containing compounds with carboxy group, nitrogen-containing compounds with sulfonyl group, nitrogen-containing compounds with hydroxy group, nitrogen-containing compounds with hydroxyphenyl group, alcoholic nitrogen-containing compounds, amide derivatives, imide derivatives, carbamate derivatives, and ammonium salts. Examples are described in Patent Document 9, for example, and any such compounds are useful. Of the foregoing basic compounds, preferred are tris[2-(methoxymethoxy)ethyl]amine, tris[2-(methoxymethoxy)ethyl]amine-N-oxide, dibutylaminobenzoic acid, morpholine derivatives and imidazole derivatives.

In the positive resist composition, the basic compound (F) is preferably added in an amount of 0 to 10 parts, and more preferably 0 to 5 parts by weight per 80 parts by weight of the base polymer (B). The basic compounds may be used alone or in admixture.

### (G) Surfactant

In the positive resist composition, any of surfactants commonly used for improving coating characteristics to the substrate may be added as an optional component. Numerous surfactants are known in the art, for example, in JP-A 2004-115630. A choice may be made with reference to such patent documents. An appropriate amount of the surfactant (G) used is 0 to 5 parts by weight per 80 parts by weight of the base polymer (B). The surfactants may be used alone or in admixture.

### Process

Another embodiment of the invention is a pattern forming process comprising the steps of applying the chemically amplified positive resist composition defined above onto a substrate to form a resist film thereon, exposing the resist film patternwise to high-energy radiation, and developing the exposed resist film in an alkaline developer to form a resist pattern.

The substrate used herein may be selected from, for example, substrates for IC fabrication, e.g., Si, SiO, SiO₂, SiN, SiON, TiN, WSi, BPSG, SOG, and organic antireflective coating, and substrates for mask circuit fabrication, e.g., Cr, CrO, CrON, MoSi₂, Si, SiO, SiO₂, SiON, SiN, SiONC, CoTa, TaBN, and SnO₂.

The resist composition is first applied onto a substrate by a suitable coating technique such as spin coating. The coating is prebaked on a hotplate preferably at a temperature of 60 to 150°C for 1 to 20 minutes, more preferably at 80 to 140°C for 1 to 10 minutes to form a resist film of 0.03 to 2 µm thick.

Then the resist film is exposed patternwise to high-energy radiation such as UV, deep-UV, excimer laser (KrF, ArF), EUV, x-ray, γ-ray, synchrotron radiation or EB. The resist composition of the invention is especially effective in the EUV or EB lithography.

On use of UV, deep-UV, EUV, excimer laser, x-ray, γ-ray or synchrotron radiation as the high-energy radiation, the resist film is exposed through a mask having a desired pattern, preferably in a dose of 1 to 500 mJ/cm², more preferably 10 to 400 mJ/cm². On use of EB, a pattern may be written directly in a dose of preferably 1 to 500 µC/cm², more preferably 10 to 400 µC/cm².

The exposure may be performed by conventional lithography whereas the immersion lithography of holding a liquid, typically water, between the mask and the resist film may be employed if desired. In the immersion lithography, a protective film which is insoluble in water may be used.

The resist film is then baked (PEB) on a hotplate preferably at 60 to 150°C for 1 to 20 minutes, more preferably at 80 to 140°C for 1 to 10 minutes.

Thereafter, the resist film is developed with a developer in the form of an aqueous base solution, for example, 0.1 to 5 wt%, preferably 2 to 3 wt% aqueous solution of tetramethylammonium hydroxide (TMAH) preferably for 0.1 to 3 minutes, more preferably 0.5 to 2 minutes by conventional techniques such as dip, puddle and spray techniques. In this way, a desired resist pattern is formed on the substrate.

From the positive resist composition, a pattern with a high resolution and improved LER and CDU can be formed. The resist composition is effectively applicable to a substrate having a surface layer of material which is likely to invite pattern stripping or pattern collapse because the resist pattern is tightly adhesive to the substrate. Exemplary substrates include a substrate having sputter deposited on its outermost surface metallic chromium or a chromium compound containing at least one light element selected from oxygen, nitrogen and carbon, a substrate having sputter deposited on its outermost surface metallic tantalum or a tantalum compound containing at least one light element selected from oxygen, nitrogen and carbon, and a substrate having an outermost surface layer of SiOₓ. The resist composition is especially effective for pattern formation on a photomask blank as the substrate.

The resist pattern forming process is successful in forming a pattern having a high resolution and improved LER and CDU through exposure and development even when a substrate having the outermost surface made of a material having a potential impact on a resist pattern profile, typically a material containing at least one element selected from chromium, silicon, tantalum, molybdenum, cobalt, nickel, tungsten and tin, e.g., photomask blank is used because the positive resist composition is effective for controlling acid diffusion on the resist film/substrate interface.

Since the positive resist composition is effective for suppressing formation of defects, a pattern of microscopic feature size can be formed on a substrate, the pattern containing a minimal number of defects.

In addition, the pattern formed from the positive resist composition can be inspected for defectiveness with light having a short wavelength of up to 400 nm. Thus, defects of microscopic size can be detected.

### EXAMPLES

Examples and Comparative Examples are given below by way of illustration and not by way of limitation. All parts are by weight (pbw). The monomer constitutional ratio in a copolymer is a molar ratio. THF stands for tetrahydrofuran. Mw is measured by GPC versus polystyrene standards. For proton nuclear magnetic resonance spectroscopy (¹H-NMR), instrument ECA-500 by JEOL Ltd. was used.

### [1] Synthesis of acid diffusion-controlling agent

### Synthesis Example 1-1: Synthesis of Compound Q-A: triphenylsulfonium 3,5-bis(trifluoromethyl)phenolate

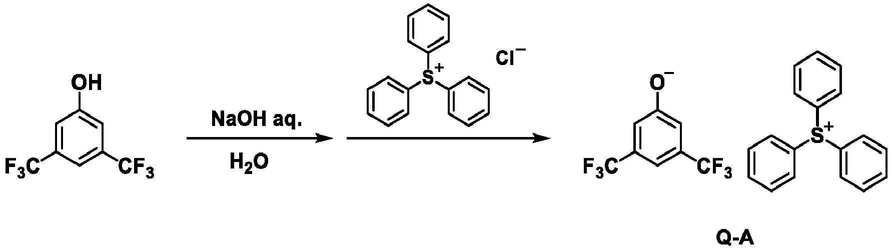

First, 200 g of deionized water was added to 50 g of reactant, 3,5-bis(trifluoromethyl)phenol, and 34.8 g of 25 wt% sodium hydroxide aqueous solution was added thereto, followed by 30 minutes of stirring. At the end of stirring, 400 g of methylene chloride and 648.5 g of 10 wt% aqueous solution of salt compound, triphenylsulfonium chloride were added to the solution, from which the organic layer was taken out. The organic layer was washed with water and concentrated under reduced pressure. Methyl isobutyl ketone (MIBK) was added to the residue, which was concentrated under reduced pressure again. Hexane was added to the residue for recrystallization. The crystal was collected and dried in vacuum, obtaining the desired compound: triphenylsulfonium 3,5-bis(trifluoromethyl)phenolate, designated Compound Q-A, (amount 100.8 g, yield 94%). FIG. 1 shows the NMR spectrum (¹H-NMR/DMSO-d₆) of Compound Q-A.

### Synthesis Examples 1-2 and 1-3: Synthesis of Compounds Q-B and Q-C

The following Compounds Q-B and Q-C were synthesized by the same procedure as in Synthesis Example 1-1 aside from changing the reactant and salt compound.

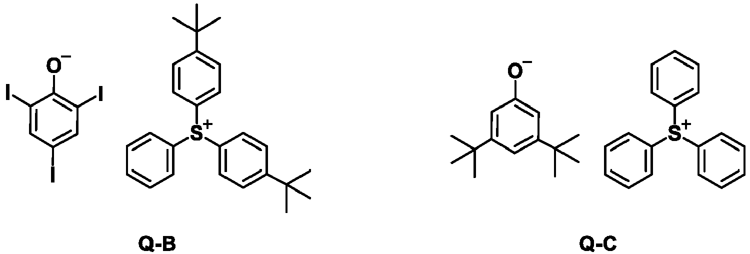

### [2] Synthesis of polymers

### Synthesis Example 2-1: Synthesis of Polymer A-1

A 3-L flask was charged with 407.5 g of acetoxystyrene, 42.5 g of acenaphthylene, and 1,275 g of toluene solvent. The reactor was cooled at -70°C under nitrogen atmosphere, after which vacuum pumping and nitrogen flow were repeated 3 times. The reactor was warmed up to room temperature, after which 34.7 g of 2,2'-azobis(2,4-dimethylvaleronitrile) (V-65 by Fujifilm Wako Pure Chemical Corp.) was added as polymerization initiator. The reactor was heated at 55°C, at which reaction took place for 40 hours. With stirring, a mixture of 970 g methanol and 180 g water was added dropwise to the reaction solution. At the end of addition, the solution was allowed to stand for 30 minutes, during which it separated into two layers. The lower layer (polymer layer) was concentrated under reduced pressure. The polymer layer was dissolved in a mixture of 0.45 L methanol and 0.54 L THF again. 160 g of triethylamine and 30 g of water were added to the solution, which was heated at 60°C, at which deprotection reaction took place for 40 hours. The reaction solution was concentrated under reduced pressure. To the concentrate, 548 g of methanol and 112 g of acetone were added. With stirring, 990 g of hexane was added dropwise to the solution. At the end of addition, the solution was allowed to stand for 30 minutes, during which it separated into two layers. To the lower layer (polymer layer), 300 g of THF was added. With stirring, 1,030 g of hexane was added dropwise to the solution. After 30 minutes of standing, the lower layer (polymer layer) was concentrated under reduced pressure. The resulting polymer solution was neutralized with 82 g of acetic acid, concentrated, dissolved in 0.3 L of acetone, and admitted into 10 L of water for precipitation. The precipitate was collected by filtration and dried, obtaining 280 g of a white polymer. On analysis by ¹H-NMR and GPC, the polymer had a copolymerization ratio of hydroxystyrene : acenaphthylene = 89.3:10.7, a Mw of 5,000, and a Mw/Mn of 1.63.

To 100 g of the polymer, 50 g of (2-methyl-1-propenyl) methyl ether was added. The reaction under acidic conditions was followed by neutralization, separatory operation, and crystallization. There was obtained 125 g of Polymer A-1.

### Synthesis Example 2-2: Synthesis of Polymers A-2 to A-7 and P-1

Polymers A-2 to A-7 and P-1 were synthesized by the same procedure as in Synthesis Example 2-1 aside from changing the type and amount of monomers.

The structure of Polymers A-1 to A-6 is shown below.

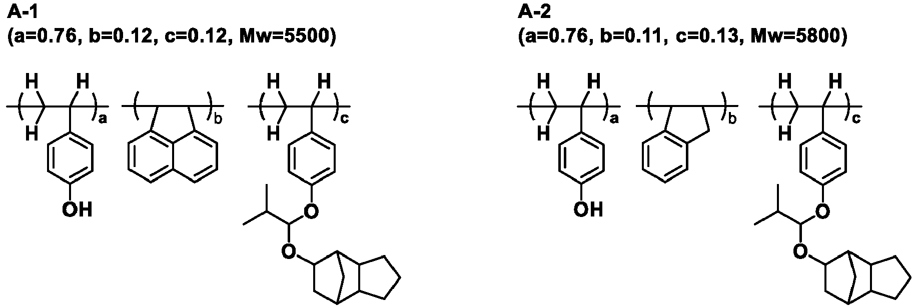

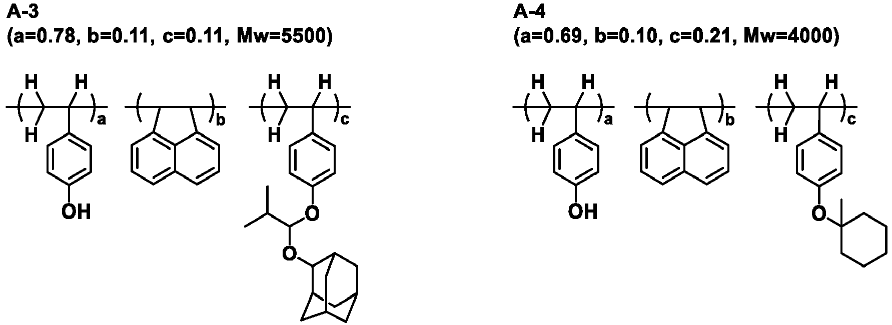

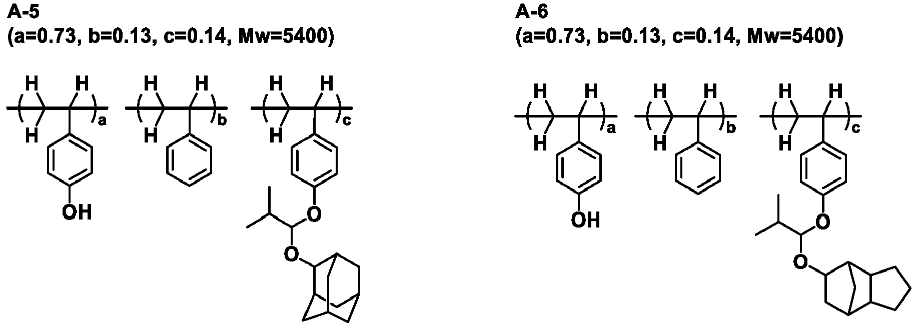

The structure of Polymer A-7 for comparison is shown below.

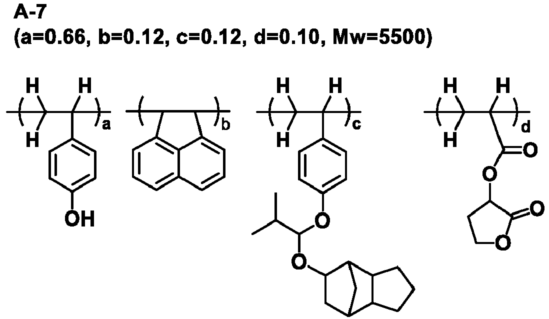

The structure of Polymer P-1 is shown below.

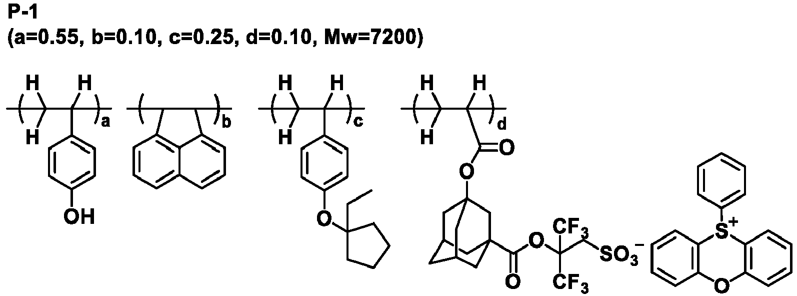

### [3] Preparation of positive resist composition

### Examples 1-1 to 1-35 and Comparative Examples 1-1 to 1-12

A chemically amplified positive resist composition (R-1 to R-35, CR-1 to CR-12) was prepared by dissolving selected components in an organic solvent in accordance with the formulation shown in Tables 1 to 3, and filtering the solution through a UPE filter with a pore size of 0.02 µm.

In the column of organic solvent in Tables 1 to 3, PGME stands for propylene glycol monomethyl ether, PGMEA for propylene glycol monomethyl ether acetate, and EL for ethyl lactate.

The comparative acid diffusion-controlling agents Q-D and Q-E, photoacid generators PAG-A to PAG-C, and fluorinated polymers C-1 and C-2 in Tables 1 to 3 are identified below.

### Q-D and Q-E:

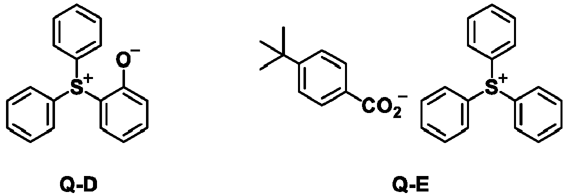

### PAG-A to PAG-C:

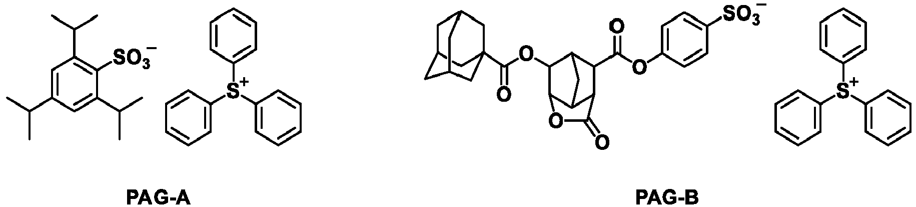

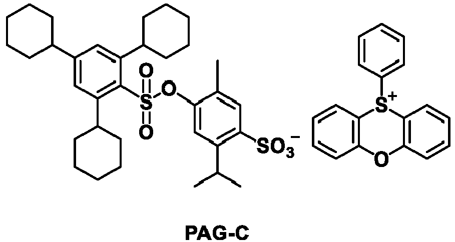

### C-1 and C-2:

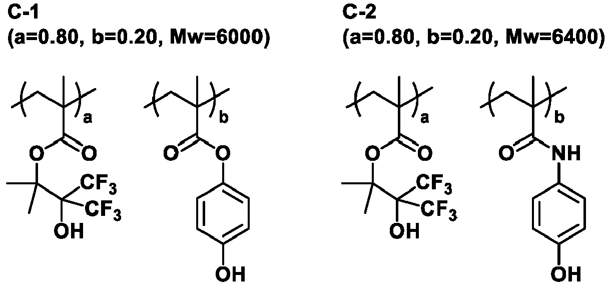

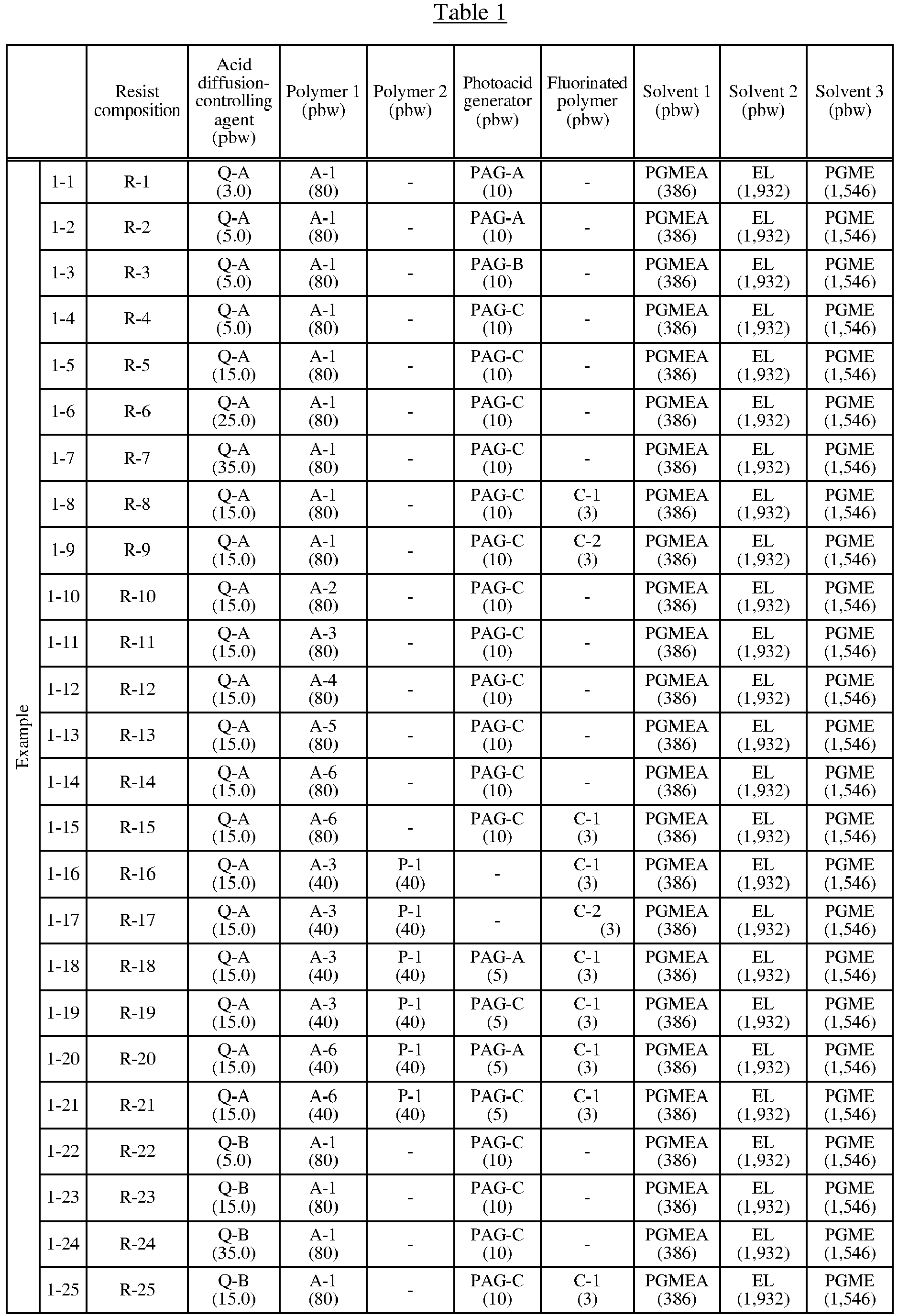

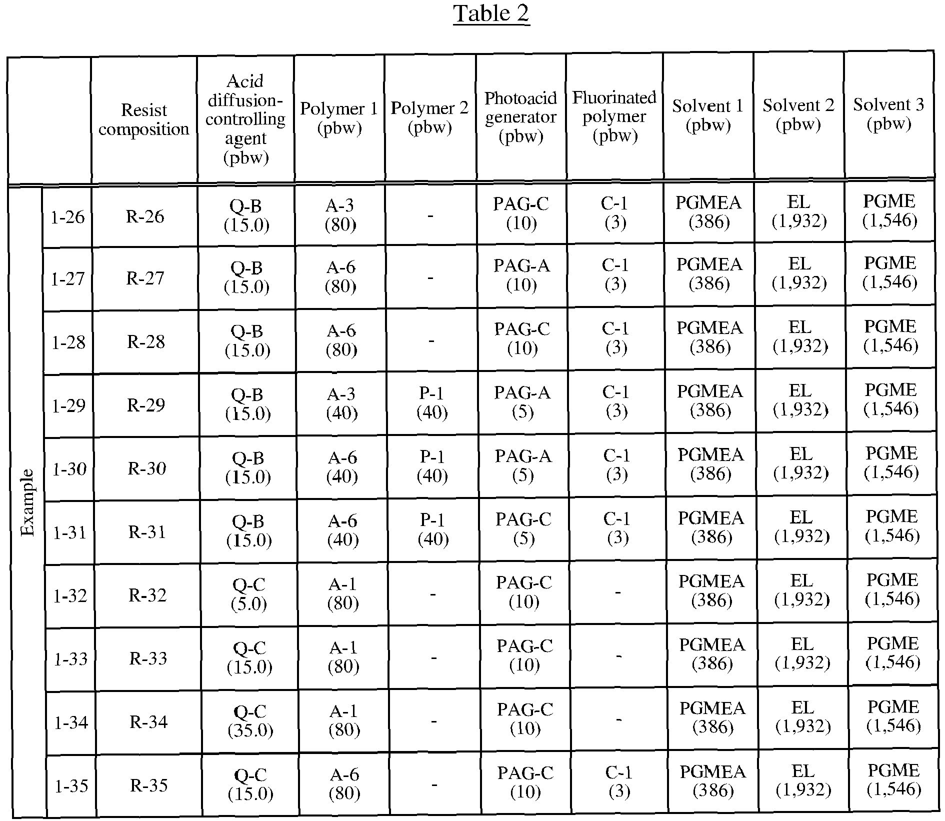

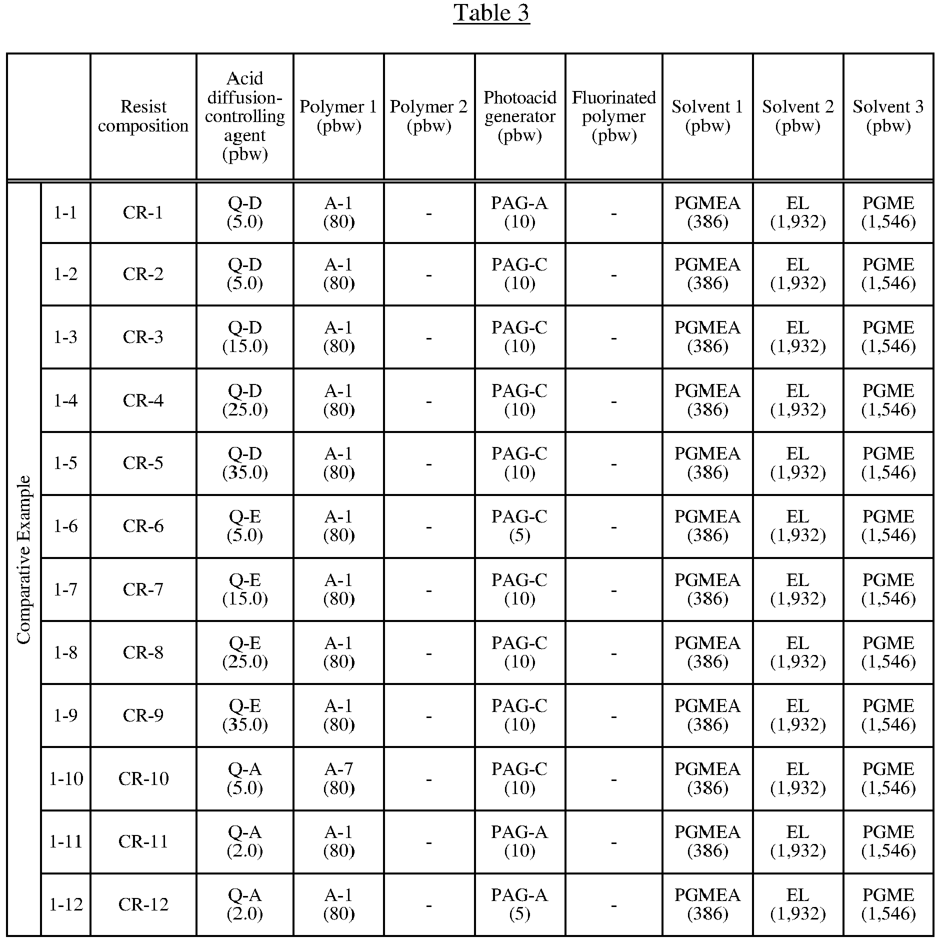

### [4] Defect evaluation

### Examples 2-1 to 2-35 and Comparative Examples 2-1 to 2-9

The chemically amplified positive resist compositions (R-1 to R-35 and CR-1 to CR-9) were prepared and stirred with a stirrer for 8 hours. The resist composition was examined by visual observation whether or not the components were dissolved in the solvent.

Using a coater/developer system ACT-M (Tokyo Electron Ltd.), each of the positive resist compositions (R-1 to R-35 and CR-1 to CR-9) was spin coated onto a mask blank having the outermost surface of a chromium film, and prebaked on a hotplate at 110°C for 600 seconds to form a resist film of 80 nm thick.

The resist film was exposed over the entire surface to EB using an EB writer system EBM-5000Plus (NuFlare Technology Inc., accelerating voltage 50 kV), then baked (PEB) at 110°C for 600 seconds, and developed in a 2.38 wt% TMAH aqueous solution. Using a mask defect inspection system M9650 (Laser Tech), development residues were evaluated. The results are shown in Tables 4 and 5.

**Table 4**

| | | Resist composition | Solvent solubility by visual observation | Defect count |
|---|---|---|---|---|
| Example | 2-1 | R-1 | Dissolved | 118 |
| | 2-2 | R-2 | Dissolved | 120 |
| | 2-3 | R-3 | Dissolved | 132 |
| | 2-4 | R-4 | Dissolved | 128 |
| | 2-5 | R-5 | Dissolved | 132 |
| | 2-6 | R-6 | Dissolved | 135 |
| | 2-7 | R-7 | Dissolved | 135 |
| | 2-8 | R-8 | Dissolved | 120 |
| | 2-9 | R-9 | Dissolved | 125 |
| | 2-10 | R-10 | Dissolved | 138 |
| | 2-11 | R-11 | Dissolved | 137 |
| | 2-12 | R-12 | Dissolved | 134 |
| | 2-13 | R-13 | Dissolved | 135 |
| | 2-14 | R-14 | Dissolved | 134 |
| | 2-15 | R-15 | Dissolved | 127 |
| | 2-16 | R-16 | Dissolved | 129 |
| | 2-17 | R-17 | Dissolved | 135 |
| | 2-18 | R-18 | Dissolved | 129 |
| | 2-19 | R-19 | Dissolved | 130 |
| | 2-20 | R-20 | Dissolved | 129 |
| | 2-21 | R-21 | Dissolved | 128 |
| | 2-22 | R-22 | Dissolved | 126 |
| | 2-23 | R-23 | Dissolved | 129 |
| | 2-24 | R-24 | Dissolved | 133 |
| | 2-25 | R-25 | Dissolved | 125 |
| | 2-26 | R-26 | Dissolved | 128 |
| | 2-27 | R-27 | Dissolved | 128 |
| | 2-28 | R-28 | Dissolved | 127 |
| | 2-29 | R-29 | Dissolved | 129 |
| | 2-30 | R-30 | Dissolved | 128 |
| | 2-31 | R-31 | Dissolved | 129 |
| | 2-32 | R-32 | Dissolved | 144 |
| | 2-33 | R-33 | Dissolved | 160 |
| | 2-34 | R-34 | Undissolved | - |
| | 2-35 | R-35 | Dissolved | 155 |

**Table 5**

| | | Resist composition | Solvent solubility by visual observation | Defect count |
|---|---|---|---|---|
| Comparative Example | 2-1 | CR-1 | Dissolved | 210 |
| | 2-2 | CR-2 | Dissolved | 206 |
| | 2-3 | CR-3 | Dissolved | 334 |
| | 2-4 | CR-4 | Dissolved | 560 |
| | 2-5 | CR-5 | Undissolved | - |
| | 2-6 | CR-6 | Dissolved | 220 |
| | 2-7 | CR-7 | Dissolved | 556 |
| | 2-8 | CR-8 | Dissolved | 945 |
| | 2-9 | CR-9 | Undissolved | - |

The chemically amplified positive resist compositions (R-1 to R-35) containing onium salt compounds having formula (A1) showed a satisfactory defect-suppression effect as compared with the comparative resist compositions (CR-1 to CR-9). Of the onium salt compounds having formula (A1), halogen-containing compounds Q-A and Q-B showed that any increase in the defect count was not found even when the amount of the compound added was increased to 35 parts by weight. In contrast, compounds Q-C to Q-E showed that agglomerates formed as the amount of the compound added was increased, leading to an increase in the defect count and insolubilization.

### [5] EB lithography test

### Examples 3-1 to 3-34 and Comparative Examples 3-1 to 3-10

Using a coater/developer system ACT-M (Tokyo Electron Ltd.), each of the positive resist compositions (R-1 to R-30 and CR-1 to CR-7) was spin coated onto a mask blank of 152 mm squares having the outermost surface of a chromium film, and prebaked on a hotplate at 110°C for 600 seconds to form a resist film of 80 nm thick. The resist film was exposed to EB using an EB writer system EBM-5000Plus (NuFlare Technology Inc., accelerating voltage 50 kV), then baked (PEB) at 110°C for 600 seconds, and developed in a 2.38 wt% TMAH aqueous solution, thereby yielding a positive pattern.

The resist pattern was evaluated as follows. The patterned mask blank was observed under a top-down scanning electron microscope (TD-SEM). The optimum dose (Eop) was defined as the exposure dose (µC/cm²) which provided a 1:1 resolution at the top and bottom of a 200-nm 1:1 line-and-space (LS) pattern. The resolution (or maximum resolution) was defined as the minimum line width of a L/S pattern that could be resolved at the optimum dose. The 200-nm LS pattern printed by exposure at the optimum dose (Eop) was observed under SEM. For each of the edges of 32 lines of the LS pattern, edge detection was carried out at 80 points, from which a 3-fold value (3σ) of the standard deviation (σ) or variation was determined and reported as LER (nm). Also, the size of lines was measured at 144 points within the blank substrate plane, from which a 3-fold value (3σ) of the standard deviation (σ) was determined and reported as CDU (nm). A smaller value indicates a LS pattern with better CDU. The results are shown in Tables 6 and 7.

**Table 6**

| | | Resist composition | Eop (µC/cm²) | Maximum resolution (nm) | LER (nm) | CDU (nm) |
|---|---|---|---|---|---|---|
| Example | 3-1 | R-1 | 27 | 37 | 4.0 | 2.6 |
| | 3-2 | R-2 | 46 | 37 | 3.7 | 2.4 |
| | 3-3 | R-3 | 48 | 37 | 3.8 | 2.4 |
| | 3-4 | R-4 | 51 | 37 | 3.9 | 2.4 |
| | 3-5 | R-5 | 102 | 37 | 3.2 | 2.1 |
| | 3-6 | R-6 | 155 | 35 | 2.4 | 1.5 |
| | 3-7 | R-7 | 210 | 32 | 2.1 | 1.3 |
| | 3-8 | R-8 | 99 | 37 | 3.1 | 2.1 |
| | 3-9 | R-9 | 100 | 37 | 3.2 | 2.1 |
| | 3-10 | R-10 | 101 | 37 | 3.3 | 2.2 |
| | 3-11 | R-11 | 102 | 37 | 3.2 | 2.1 |
| | 3-12 | R-12 | 115 | 37 | 3.1 | 2.1 |
| | 3-13 | R-13 | 99 | 37 | 3.0 | 2.0 |
| | 3-14 | R-14 | 99 | 37 | 2.9 | 1.9 |
| | 3-15 | R-15 | 97 | 37 | 2.9 | 1.9 |
| | 3-16 | R-16 | 90 | 37 | 3.0 | 2.0 |
| | 3-17 | R-17 | 94 | 37 | 2.8 | 1.8 |
| | 3-18 | R-18 | 89 | 35 | 2.7 | 1.8 |
| | 3-19 | R-19 | 90 | 32 | 2.6 | 1.7 |
| | 3-20 | R-20 | 88 | 35 | 2.6 | 1.8 |
| | 3-21 | R-21 | 89 | 32 | 2.5 | 1.6 |
| | 3-22 | R-22 | 48 | 35 | 3.9 | 2.5 |
| | 3-23 | R-23 | 98 | 35 | 3.3 | 2.2 |
| | 3-24 | R-24 | 201 | 32 | 2.2 | 1.4 |
| | 3-25 | R-25 | 97 | 35 | 3.2 | 2.1 |
| | 3-26 | R-26 | 96 | 37 | 3.1 | 2.1 |
| | 3-27 | R-27 | 93 | 37 | 3.4 | 2.3 |
| | 3-28 | R-28 | 95 | 35 | 3.1 | 2.0 |
| | 3-29 | R-29 | 88 | 35 | 2.9 | 1.9 |
| | 3-30 | R-30 | 87 | 35 | 2.8 | 1.9 |
| | 3-31 | R-31 | 92 | 32 | 2.7 | 1.8 |
| | 3-32 | R-32 | 58 | 37 | 3.9 | 2.6 |
| | 3-33 | R-33 | 118 | 37 | 3.6 | 2.4 |
| | 3-34 | R-35 | 114 | 37 | 3.5 | 2.4 |

**Table 7**

| | | Resist composition | Eop (µC/cm²) | Maximum resolution (nm) | LER (nm) | CDU (nm) |
|---|---|---|---|---|---|---|
| Comparative Example | 3-1 | CR-1 | 61 | 45 | 5.1 | 3.8 |
| | 3-2 | CR-2 | 64 | 40 | 4.9 | 3.6 |
| | 3-3 | CR-3 | 121 | 40 | 4.6 | 3.4 |
| | 3-4 | CR-4 | 168 | 40 | 4.5 | 3.1 |
| | 3-5 | CR-6 | 45 | 50 | 5.4 | 4.0 |
| | 3-6 | CR-7 | 91 | 45 | 5.1 | 3.7 |
| | 3-7 | CR-8 | 142 | 45 | 4.9 | 3.3 |
| | 3-8 | CR-10 | 49 | 40 | 5.4 | 4.2 |
| | 3-9 | CR-11 | 18 | 45 | 6.5 | 4.6 |
| | 3-10 | CR-12 | 32 | 45 | 6.8 | 4.8 |

All the inventive resist compositions comprising the onium salt compounds having formula (A1) show high resolution and satisfactory values of LER and CDU as compared with the comparative resist compositions.

Of the onium salt compounds having formula (A1), those compounds containing fluorine, chlorine, bromine or iodine, like Compounds Q-A and Q-B, are highly soluble in organic solvents, and they do not agglomerate even when they are added in a large amount. Fully improved LER and CDU are obtained as demonstrated by Examples 3-7 and 3-24.

The resist composition (CR-10) containing Polymer A-7 having a lactone skeleton is less resistant to developer due to a lowering of lipophilicity, and thus degraded in pattern profile. Comparative Example 3-8 demonstrates that its resolution, LER and CDU are inferior to those of the inventive resist compositions.

The resist composition (CR-11) wherein the ratio of the PAG to the onium salt compound having formula (A1) is more than 4 fails to fully suppress acid diffusion. Comparative Example 3-9 demonstrates that its resolution, LER and CDU are inferior to those of the inventive resist compositions.

The resist composition (CR-12) wherein the total amount of the PAG and the onium salt compound having formula (A1) is less than 10 pbw fails to gain a sufficient number of acid generation sites in the exposed region and fails to fully suppress acid diffusion. Comparative Example 3-10 demonstrates that its resolution, LER and CDU are inferior to those of the inventive resist compositions.

### [6] Measurement of extinction coefficient (k)

### Examples 4-1 to 4-9 and Comparative Examples 4-1 to 4-3

A test substrate was prepared by spin coating each of the chemically amplified positive resist compositions shown in Table 8 onto a silicon wafer so as to reach a film thickness of 100 nm. An extinction coefficient (k) was measured by using VUV-VASE (J. A. Woollam) and irradiating light of wavelength 400 nm, 355 nm, 330 nm or 300 nm to the test substrate. In order that the resist film avoid light exposure during irradiation of inspection light, the k value is preferably up to 0.01, more preferably up to 0.003. The results are shown in Table 8.

**Table 8**

| | | Resist composition | k value @400 nm | k value @355 nm | k value @330 nm | k value @300 nm |
|---|---|---|---|---|---|---|
| Example | 4-1 | R-4 | 0.001 | 0.001 | 0.001 | 0.003 |
| | 4-2 | R-5 | 0.001 | 0.002 | 0.002 | 0.004 |
| | 4-3 | R-6 | 0.001 | 0.002 | 0.002 | 0.004 |
| | 4-4 | R-7 | 0.001 | 0.002 | 0.002 | 0.006 |
| | 4-5 | R-22 | 0.001 | 0.001 | 0.001 | 0.004 |
| | 4-6 | R-23 | 0.001 | 0.002 | 0.002 | 0.005 |
| | 4-7 | R-24 | 0.001 | 0.002 | 0.002 | 0.006 |
| | 4-8 | R-32 | 0.001 | 0.001 | 0.001 | 0.005 |
| | 4-9 | R-33 | 0.001 | 0.002 | 0.002 | 0.008 |
| Comparative Example | 4-1 | CR-2 | 0.011 | 0.011 | 0.011 | 0.035 |
| | 4-2 | CR-3 | 0.011 | 0.012 | 0.013 | 0.038 |
| | 4-3 | CR-4 | 0.012 | 0.015 | 0.017 | 0.042 |

The onium salt compounds having formula (A1) showed satisfactory k values of up to 0.01 at any wavelengths and more satisfactory k values of up to 0.003 at wavelengths 400 nm, 355 nm and 330 nm. Comparative Examples showed k values in excess of 0.01 at any wavelengths, allowing the resist film to be exposed.

### [7] EB lithography test after coating of antistatic film

### Examples 5-1 to 5-9 and Comparative Examples 5-1 to 5-5

Using a coater/developer system ACT-M (Tokyo Electron Ltd.), each of the positive resist compositions shown in Table 9 was spin coated onto a mask blank of 152 mm squares having the outermost surface of a chromium film and baked on a hotplate at 110°C for 600 seconds to form a resist film of 80 nm thick. A conductive polymer composition was spin coated onto the resist film and baked on a hotplate at 70°C for 600 seconds to form an antistatic film of 15 nm thick. The resist film was exposed to EB using an EB writer system EBM-5000Plus (NuFlare Technology Inc., accelerating voltage 50 kV), then baked (PEB) at 110°C for 600 seconds, and developed in a 2.38 wt% TMAH aqueous solution, thereby yielding a positive pattern.

The resist pattern was evaluated as follows. The patterned mask blank was observed under a TD-SEM. The optimum dose (Eop) was defined as the exposure dose (µC/cm²) which provided a 1:1 resolution at the top and bottom of a 200-nm 1:1 line-and-space (LS) pattern. The resolution (or maximum resolution) was defined as the minimum line width of a L/S pattern that could be resolved at the optimum dose. The results are shown in Table 9.

**Table 9**

| | | Resist composition | Eop (µC/cm²) | Maximum resolution (nm) |
|---|---|---|---|---|
| Example | 5-1 | R-4 | 50 | 37 |
| | 5-2 | R-5 | 100 | 37 |
| | 5-3 | R-6 | 153 | 35 |
| | 5-4 | R-7 | 207 | 32 |
| | 5-5 | R-22 | 47 | 37 |
| | 5-6 | R-23 | 96 | 37 |
| | 5-7 | R-24 | 199 | 35 |
| | 5-8 | R-32 | 54 | 40 |
| | 5-9 | R-33 | 110 | 40 |
| Comparative Example | 5-1 | CR-2 | 58 | 45 |
| | 5-2 | CR-3 | 114 | 45 |
| | 5-3 | CR-4 | 160 | 45 |
| | 5-4 | CR-6 | 40 | 70 |
| | 5-5 | CR-7 | 82 | 60 |

Of the onium salt compounds having formula (A1), the positive resist compositions containing halogen-containing compounds Q-A and Q-B showed fully satisfactory resolution even when an antistatic film was coated thereon. The resist compositions containing compounds Q-C and Q-D showed satisfactory resolution. The resist composition containing compound Q-E showed poor resolution. This is probably because unwanted reaction takes place in the unexposed region that a few protective groups on the base polymer are deprotected with very weak acid in the antistatic film. Compounds Q-A to Q-D have a highly basic structure which is likely to trap acid and thus avoid the unwanted reaction. Since Compound Q-A, owing to fluorine contained therein, is localized near the interface between the resist film and the antistatic film coated thereon, it can effectively trap very weak acid in the antistatic film and thus contributes to a quite satisfactory resolution. Since Compound Q-B, owing to iodine contained therein, does not agglomerate in the resist film and is uniformly distributed in the resist film, it can effectively trap very weak acid in the antistatic film and thus contributes to a quite satisfactory resolution.

It is evident from the foregoing that using the chemically amplified positive resist composition of the invention, a pattern having a very high resolution, reduced LER, improved CDU, and minimal defects is formed. Since the resist film is not sensitive to light of short wavelength, more microscopic defects can be detected by inspection using a light source of short wavelength. The resist pattern forming process using the chemically amplified positive resist composition is effective in the photolithography for the fabrication of semiconductor devices, especially the processing of photomask blanks.

## Claims

1. A chemically amplified positive resist composition comprising
(A) an onium salt compound having the formula (A1),
(B) a base polymer containing a polymer comprising repeat units having the formula (B1) and adapted to be decomposed under the action of acid to increase its solubility in alkaline developer, but not containing a polymer comprising lactone ring-bearing repeat units, and
(C) a photoacid generator,
wherein the content of repeat units of aromatic ring structure is at least 65 mol% of the overall repeat units of the polymer in the base polymer, a ratio of the amount of the photoacid generator to the amount of the onium salt compound having formula (A1) is less than 4, the amount of the photoacid generator is at least 5 parts by weight per 80 parts by weight of the polymer, the total amount of the onium salt compound having formula (A1) and the photoacid generator is at least 10 parts by weight per 80 parts by weight of the polymer, 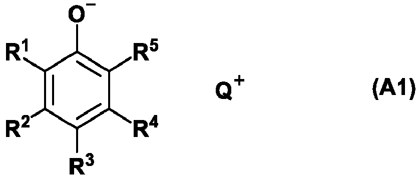 wherein R¹ to R⁵ are each independently hydrogen, halogen, nitro, cyano, aldehyde, a C₁-C₁₈ hydrocarbyl group which may contain a heteroatom, -C(O)OR⁶, -C(O)R⁷, -OR⁸, -S(O)₂R⁹, or -S(O)₂N(R¹⁰)₂, wherein R⁶ and R⁷ are each independently a C₁-C₁₉ hydrocarbyl group which may contain a heteroatom, R⁸ and R⁹ are each independently a C₁-C₂₀ hydrocarbyl group which may contain a heteroatom, R¹⁰ is each independently hydrogen or a C₁-C₂₀ hydrocarbyl group which may contain a heteroatom,
Q⁺ is a sulfonium cation having the formula (A2) or iodonium cation having the formula (A3): 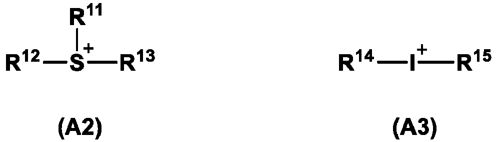 wherein R¹¹ to R¹⁵ are each independently a C₁-C₂₀ hydrocarbyl group which may contain a heteroatom, R¹¹ and R¹² may bond together to form a ring with the sulfur atom to which they are attached, 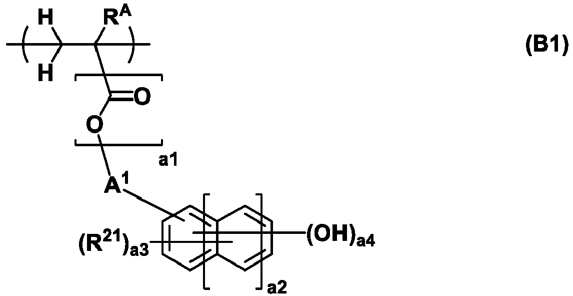 wherein R^{A} is hydrogen, fluorine, methyl or trifluoromethyl,
a1 is 0 or 1, a2 is an integer of 0 to 2, a3 is an integer meeting 0 ≤ a3 ≤ 5+2a2-a4, a4 is an integer of 1 to 3,
R²¹ is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group,
A¹ is a single bond or a C₁-C₁₀ saturated hydrocarbylene group in which any constituent -CH₂- may be replaced by -O-.

2. The resist composition of claim 1 wherein at least one of R¹ to R⁵ is a group containing fluorine, chlorine, bromine or iodine.

3. The resist composition of claim 1 or 2 wherein the repeat unit having formula (B1) has the formula (B1-1): 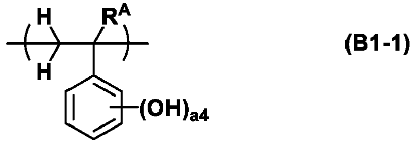 wherein R^{A} and a4 are as defined above.

4. The resist composition of any one of claims 1 to 3 wherein the polymer further comprises repeat units having the formula (B2): 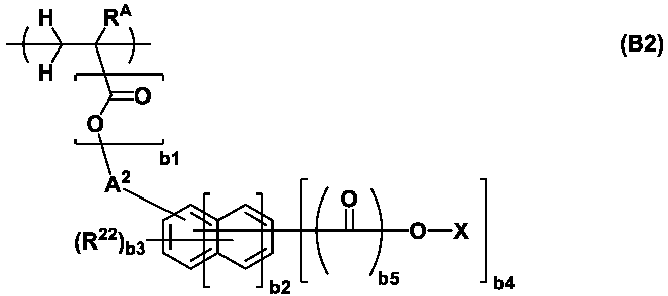 wherein R^{A} is as defined above,
b1 is 0 or 1, b2 is an integer of 0 to 2, b3 is an integer meeting 0 ≤ b3 ≤ 5+2b2-b4, b4 is an integer of 1 to 3, b5 is 0 or 1,
R²² is halogen, an optionally halogenated C₂-C₈ saturated hydrocarbylcarbonyloxy group, optionally halogenated C₁-C₆ saturated hydrocarbyl group, or optionally halogenated C₁-C₆ saturated hydrocarbyloxy group,
A² is a single bond or a C₁-C₁₀ saturated hydrocarbylene group in which any constituent -CH₂- may be replaced by -O-,
X is an acid labile group when b4 is 1, and hydrogen or an acid labile group, at least one X being an acid labile group, when b4 is 2 or 3.

5. The resist composition of any one of claims 1 to 4 wherein the polymer further comprises repeat units of at least one type selected from repeat units having the formula (B3), repeat units having the formula (B4), and repeat units having the formula (B5): 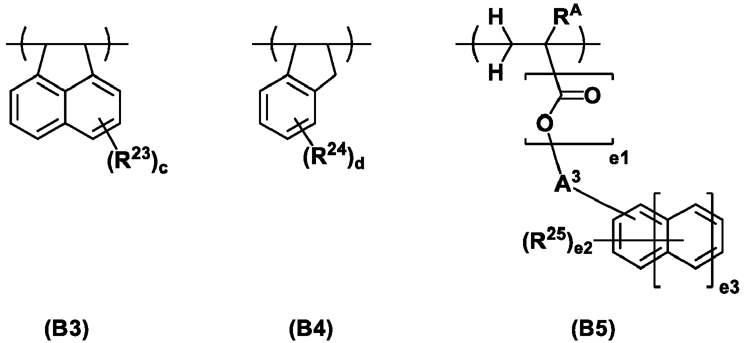 wherein R^{A} is as defined above,
c and d are each independently an integer of 0 to 4, e1 is 0 or 1, e2 is an integer of 0 to 5, e3 is an integer of 0 to 2,
R²³ and R²⁴ are each independently hydroxy, halogen, an optionally halogenated C₂-C₈ saturated hydrocarbylcarbonyloxy group, optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group,
R²⁵ is acetyl, a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro, cyano, sulfinyl or sulfonyl, and
A³ is a single bond or a C₁-C₁₀ saturated hydrocarbylene group in which any constituent -CH₂- may be replaced by -O-.

6. The resist composition of any one of claims 1 to 5 wherein the polymer further comprises repeat units of at least one type selected from repeat units having the formulae (B6) to (B13): 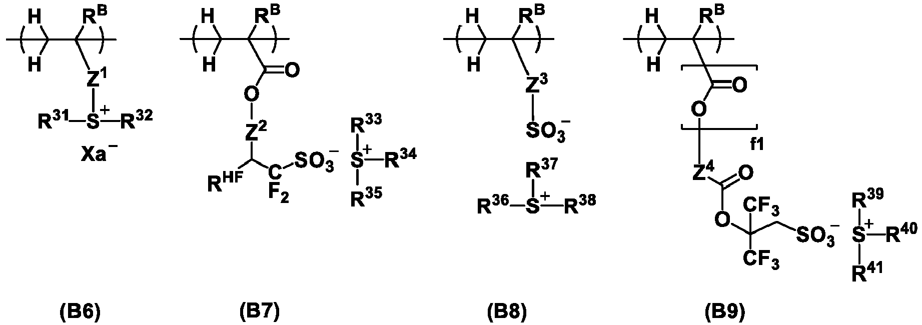 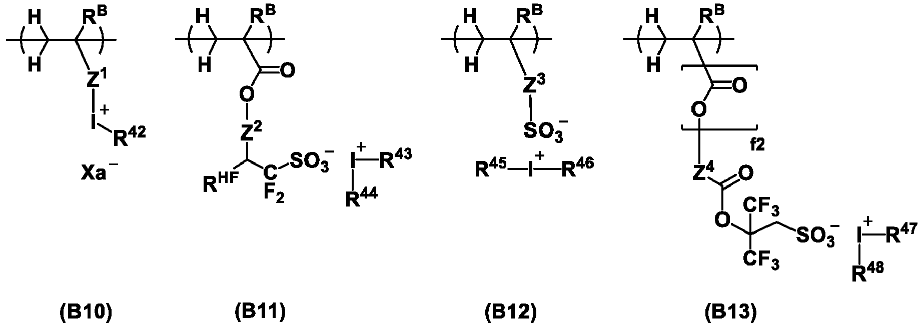 wherein R^{B} is hydrogen or methyl,
Z¹ is a single bond, a C₁-C₆ aliphatic hydrocarbylene group, phenylene group, naphthylene group or C₇-C₁₈ group obtained by combining the foregoing, -O-Z¹¹-, - C(=O)-O-Z¹¹-, or -C(=O)-NH-Z¹¹-, Z¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety,
Z² is a single bond or -Z²¹-C(=O)-O-, Z²¹ is a C₁-C₂₀ hydrocarbylene group which may contain a heteroatom,
Z³ is a single bond, methylene, ethylene, phenylene, fluorinated phenylene, trifluoromethyl-substituted phenylene, -O-Z³¹-, -C(=O)-O-Z³¹-, or -C(=O)-NH-Z³¹-, Z³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety,
Z⁴ is a single bond or C₁-C₃₀ hydrocarbylene group which may contain a heteroatom, f1 and f2 are each independently 0 or 1, f1 and f2 are 0 when Z⁴ is a single bond,
R³¹ to R⁴⁸ are each independently a C₁-C₂₀ hydrocarbyl group which may contain a heteroatom, R³¹ and R³² may bond together to form a ring with the sulfur atom to which they are attached, R³³ and R³⁴, R³⁶ and R³⁷, or R³⁹ and R⁴⁰ may bond together to form a ring with the sulfur atom to which they are attached,
R^{HF} is hydrogen or trifluoromethyl, and
Xa⁻ is a non-nucleophilic counter ion.

7. The resist composition of any one of claims 1 to 6, further comprising (D) a polymer comprising repeat units having the following formula (D1), and repeat units of at least one type selected from repeat units having the following formulae (D2) to (D5): 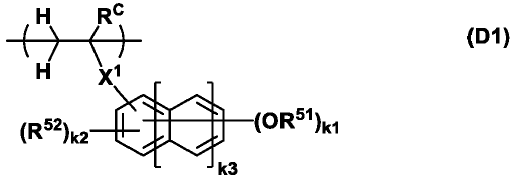 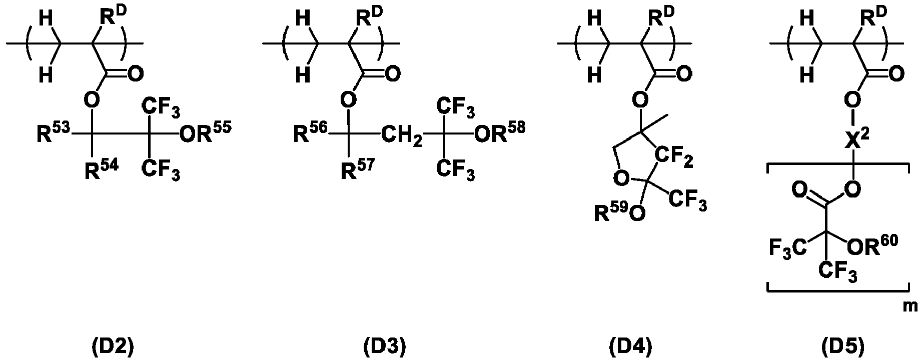 wherein R^{C} is each independently hydrogen or methyl,
R^{D} is each independently hydrogen, fluorine, methyl or trifluoromethyl,
R⁵¹ is hydrogen or a C₁-C₅ straight or branched hydrocarbyl group in which a heteroatom-containing moiety may intervene in a carbon-carbon bond,
R⁵² is a C₁-C₅ straight or branched hydrocarbyl group in which a heteroatom-containing moiety may intervene in a carbon-carbon bond,
R⁵³, R⁵⁴, R⁵⁶ and R⁵⁷ are each independently hydrogen or a C₁-C₁₀ saturated hydrocarbyl group,
R⁵⁵, R⁵⁸, R⁵⁹ and R⁶⁰ are each independently hydrogen or a C₁-C₁₅ hydrocarbyl group, C₁-C₁₅ fluorinated hydrocarbyl group, or acid labile group, when R⁵⁵, R⁵⁸, R⁵⁹ and R⁶⁰ each are a hydrocarbyl or fluorinated hydrocarbyl group, an ether bond or carbonyl moiety may intervene in a carbon-carbon bond,
k1 is an integer of 1 to 3, k2 is an integer meeting 0 ≤ k2 ≤ 5+2k3-k1, k3 is 0 or 1, m is an integer of 1 to 3,
X¹ is a single bond, -C(=O)-O- or -C(=O)-NH-, and
X² is a C₁-C₂₀ (m+1)-valent hydrocarbon group or C₁-C₂₀ (m+1)-valent fluorinated hydrocarbon group.

8. The resist composition of any one of claims 1 to 7, further comprising (E) an organic solvent.

9. The resist composition of any one of claims 1 to 8 which forms a resist film having an extinction coefficient (k value) of up to 0.01 relative to inspection light of wavelength 300 to 400 nm.

10. A resist pattern forming process comprising the steps of:
applying the chemically amplified positive resist composition of any one of claims 1 to 9 onto a substrate to form a resist film thereon,
exposing the resist film patternwise to high-energy radiation, and
developing the exposed resist film in an alkaline developer.

11. The process of claim 10 wherein the high-energy radiation is EUV or EB.

12. The process of claim 10 or 11 wherein the substrate has the outermost surface of a material containing at least one element selected from chromium, silicon, tantalum, molybdenum, cobalt, nickel, tungsten, and tin.

13. The process of any one of claims 10 to 12 wherein the substrate is a photomask blank.

14. A photomask blank comprising a resist film of the chemically amplified positive resist composition of any one of claims 1 to 9.

15. The photomask blank of claim 14, further comprising an antistatic film.
